# EUROPEAN PATENT APPLICATION

(11) **EP 1 667 217 A1**
(43) Date of publication of application: **07.06.2006**
(21) Application number: 04772422.4
(22) Date of filing: 30.08.2004
(51) Int. Cl.: H01L 21/31, C23C 16/455

(54) **GAS TREATMENT DEVICE AND HEAT READITING METHOD**

(30) Priority: 03.09.2003 JP 2003311903
(71) Applicant: TOKYO ELECTRON LIMITED, Minato-ku, Tokyo 107-8481 (JP)
(72) Inventor: IIZUKA, Hachishiro, c/o Tokyo Electron at Limited, Nirasaki-shi, Yamanashi 407-0192 (JP); KIMURA, Koichiro, c/o Tokyo Electron at Limited, Nirasaki-shi, Yamanashi 407-0192 (JP); IKEDA, Kyoko, c/o Tokyo Electron at Limited, Nirasaki-shi, Yamanashi 407-0192 (JP); SAKODA, Tomoyuki, c/o Tokyo Electron at Limited, Nirasaki-shi, Yamanashi 407-0192 (JP); YASUMURO, Akira, c/o Tokyo Electron at Limited, Nirasaki-shi, Yamanashi 407-0192 (JP)
(74) Representative: HOFFMANN EITLE
(86) International application number: PCT/JP2004/012466
(87) International publication number: WO 2005/024928

(57) **Abstract**

A shower head (40) formed by stacking a shower base (41), a gas diffusion plate (42), and a shower plate (43) and supplying material gas and oxidizer gas to a wafer W on a loading table (5) through a first gas diffusion part (42a) and a second gas diffusion part (42b) formed in both faces of the gas diffusion plate (42), first gas outlets (43a) formed in the shower plate (43) and communicating with a first gas diffusion space (42c), and second gas outlets (43b) formed in the shower plate (43) and communicating with a second gas diffusion space (42d). A plurality of heat transfer columns (42e) fitted closely to the lower surface of the shower base (41) are installed in the first gas diffusion part (42a) so that portions therebetween can form the first gas diffusion space (42c), and radiant heat from the loading table (5) is transmitted by the heat transfer columns (42e) in the thickness direction of the shower head (40).

## Description

### Technical Field

The present invention relates to a gas processing device for applying a gas processing to a target substrate to be processed, by using a process gas and a heat radiating method applied to a process gas discharging mechanism included in the particular gas processing device.

### Background Art

In the manufacturing process of a semiconductor device, thin films consisting of various substances are formed on a semiconductor wafer (hereinafter referred to simply as "wafer") used as a target substrate to be processed, and the combinations of the substances used for forming the thin films are being diversified and being made complex in accordance with the diversification of the properties required for the thin films.

For example, in order to overcome the limit of the performance achieved by the refresh operation of the DRAM (Dynamic Random Access Memory) element in a semiconductor memory element, the development of a large capacity memory element has been carried out by using a ferroelectric thin film in a ferroelectric capacitor. A ferroelectric random access memory (FeRAM) using such as ferroelectric thin film, which is a kind of a nonvolatile memory element, attracts attentions as a next generation memory element because the FeRAM does not require in principle a refresh operation thereby producing the merit that the storage information can be retained even under the state that the power supply has been cut off and because the operating speed of the FeRAM is fully comparable to that of the DRAM.

An insulating material such as mainly SrBi₂Ta₂O₉ (SBT) or Pb(Zr, Ti)O₃(PZT) is used for forming the ferroelectric thin film for the FeRAM. A MOCVD technology in which a thin film is formed by utilizing the thermal decomposition of a gasified organometallic compound is adapted for forming accurately thin films consisting of a plurality of elements and having a complex composition. The film formation by the MOCVD technology is disclosed in, for example, Japanese Patent Disclosure (Kokai) No. 8-291385.

In the general CVD technology, which is not limited to the MOCVD technology, a raw material gas is supplied onto a heated semiconductor wafer disposed on a mounting table from a shower head arranged to face the mounting table supporting the semiconductor wafer to form a thin film on the semiconductor wafer by utilizing the thermal decomposition reaction and a reducing reaction of the raw material gas. In general, a flat gas diffusion space, which is a space, of the size substantially equal to the diameter of the semiconductor wafer is formed in the shower head so as to supply the raw material gas uniformly onto the semiconductor wafer, and a large number of gas blowing ports communicating with the space for the gas diffusion are arranged in a dispersed fashion on the surface of the shower head facing the gas diffusion space.

However, where a flat space for the gas diffusion is formed inside the shower head as described above, the transmission of the heat (radiation of heat) to the back surface is inhibited by the gas diffusion space, with the result that the shower head is heated by the radiation heat generated from the mounting table heating the semiconductor wafer with increase in the number of repetitions of the film forming operation. Also, where such a flat space for the gas diffusion is formed inside the shower head, the heat transmission is rendered insufficient, thereby making it difficult to perform the temperature control effectively, even if the temperature is to be controlled from the upper portion, i.e., from the atmosphere side, as in the ordinary method.

Particularly, the thermal decomposition of the raw material gas is utilized in the MOCVD, with the result that, if the temperature of the shower head is elevated to exceed the thermal decomposition temperature of the raw material gas, an undesirable thermal decomposition reaction is generated in the inner region of the shower head and within the pipes in front of the shower head. As a result, the concentration of the raw material gas is lowered and the deposited material is attached as a foreign substance to the semiconductor wafer so as to cause the defective film formation. It should also be noted that the film-forming temperature is changed with time as pointed out above so as to cause the nonuniformity in the film quality and the film composition.

### Disclosure of Invention

An object of the present invention is to provide a gas processing device, which permits suppressing the defect and nonuniformity of the processing derived from the temperature elevation of the process gas discharging mechanism such as a shower head, and to provide a heat radiating method.
Another object of the present invention is to provide a gas processing device, which permits shortening and simplifying the gas supply pathway to the process gas discharging mechanism such as a shower head.

According to a first aspect of the present invention, there is provided a gas processing device, comprising a process chamber accommodating a target substrate; a mounting table arranged within the process chamber for mounting the target substrate; a process gas discharging mechanism arranged to face the mounting table for discharging the process gas into the process chamber; and an exhaust mechanism for exhausting the process chamber, wherein the process gas discharging mechanism comprises a gas introducing portion for introducing the process gas into the process gas discharging portion, a gas discharging portion having a plurality of gas discharging holes for discharging the process gas toward the mounting table, and a gas diffusing portion arranged between the gas introducing portion and the gas discharging portion; and wherein the gas diffusing portion includes a plurality of heat transfer columns for performing the heat transmission between the gas introducing portion and the gas discharging portion, and a gas diffusing space communicating with the gas discharging holes and constituting the portion other than the heat transfer columns.

According to a second aspect of the present invention, there is provided a gas processing device, comprising a process chamber accommodating a target substrate; a mounting table arranged within the process chamber for mounting the target substrate; a process gas discharging mechanism arranged to face the target substrate disposed on the mounting table for discharging the process gas into the process chamber; and an exhaust mechanism for exhausting the process chamber, wherein the process gas discharging mechanism comprises a first plate onto which each of a first process gas and a second process gas is introduced, a second plate connecting to the surface of the first plate, a third plate connecting to the second plate and including a plurality of first and second gas discharging holes formed corresponding to the target substrate disposed on the mounting table, a first gas diffusion portion arranged between the first plate and the second plate, and a second gas diffusion portion arranged between the second plate and the third plate, and wherein the first gas diffusion portion has a plurality of first columns connected to the first plate and the second plate, and a first gas diffusion space communicating with the first gas discharging holes and constituting the portion other than the plural first columns; the second gas diffusion portion has a plurality of second columns connected to the second plate and the third plate, and a second gas diffusion space communicating with the second gas discharging holes and constituting the portion other than the plural second columns, and wherein the introduced first process gas is discharging from the first gas discharging holes through the first gas diffusion space, and the introduced second process gas is discharged from the second gas discharging holes through the second gas diffusion space.

According to a third aspect of the present invention, there is provided a gas processing device, comprising a process chamber accommodating a target substrate; a mounting table arranged within the process chamber for mounting the target substrate; a process gas discharging mechanism arranged in a position to face the target substrate disposed on by the mounting table for discharging first and second process gases into the process chamber; and an exhaust mechanism for exhausting the process chamber, wherein the process gas discharging mechanism includes a gas introducing portion for introducing the first and second process gases into the process gas discharging mechanism, a gas discharging portion provided with a plurality of first and second gas discharging holes for discharging the first process gas and the second process gas toward the mounting table, and first and second flat gas diffusion portions stacked one upon the other in the region between the gas introducing portion and the gas discharging portion; the first gas diffusion portion includes a plurality of first columns for performing the heat transmission between the gas discharging portion and the gas introducing portion, and a first gas diffusion space communicating with the first gas discharging holes and constituting the portion other than the plural first columns; the second gas diffusion portion includes a plurality of second columns each provided with a gas flowing hole through which the first process gas is flows, and a second gas diffusion space communicating with the second gas discharging holes and constituting the portion other than the plural second columns; and wherein the introduced first process gas is discharged from the first gas discharging holes through the first gas diffusion space, and the introduced second process gas is discharged from the second gas discharging holes through the second gas diffusion space.

According to a fourth aspect of the present invention, there is provided a gas processing device, comprising a process chamber accommodating a target substrate; a mounting table arranged in the process chamber for mounting the target substrate; a process gas discharging mechanism arranged in a position to face the mounting table for discharging the process gas into the process chamber; an exhaust mechanism for exhausting the process chamber; and a temperature control mechanism of the process gas discharging mechanism; wherein the process gas discharging mechanism includes a gas introducing portion for introducing the process gas into the process gas discharging mechanism, a gas discharging portion provided with a plurality of gas discharging holes for discharging the process gas toward the mounting table, and a gas diffusion portion arranged between the gas introducing portion and the gas discharging portion; and wherein the gas diffusion portion includes a heat transfer column for performing the heat transmission between the gas introducing portion and the gas discharging portion, and a gas diffusion space communicating with the gas discharging hole and constituting the portion other than the heat transfer column; and wherein the temperature control mechanism includes a heat dissipating mechanism for dissipating the heat transmitted from the lower portion of the process gas introducing portion through the heat transfer column.

According to a fifth aspect of the present invention, there is provided a heat radiating method of a process gas discharging mechanism included in a gas processing device comprising a process chamber accommodating a target substrate, a mounting table arranged within the process chamber for mounting the target substrate, a process gas discharging mechanism arranged in a position to face the mounting table for discharging the process gas into the process chamber, and an exhaust mechanism for exhaust the process chamber, wherein the process gas discharging mechanism includes a gas introducing portion for introducing the process gas into the process gas discharging mechanism, a gas discharging portion provided with a plurality of gas discharging holes for discharging the process gas toward the mounting table, and a gas diffusion portion arranged between the gas introducing portion and the gas discharging portion for diffusing the process gas in the process gas diffusion space provided therein to guide the process gas to the gas discharging holes, the method comprising forming heat transfer columns in the gas diffusion portion; and carrying out the heat transmission between the gas introducing portion and the gas discharging portion through the heat transfer columns to dissipate the heat from the process gas discharging mechanism.

According to a sixth aspect of the present invention, there is provided a heat radiating method of a process gas discharging mechanism included in a gas processing device comprising a process chamber accommodating a target substrate, a mounting table arranged within the process chamber for mounting the target substrate, a process gas discharging mechanism arranged in a position to face the target substrate arranged on the mounting table for discharging the process gas into the process chamber, and an exhaust mechanism for exhausting the process chamber, wherein the process gas discharging mechanism includes a first plate onto which each of a first process gas and a second process gas is introduced, a second plate connecting to the first plate, a third plate connecting to the second plate and provided with a plurality of first and second gas discharging holes formed to conform with the target substrate discharged by the mounting table, a first gas diffusion portion arranged between the first plate and the second plate, and a second gas diffusion portion arranged between the second plate and the third plate, the method comprising forming a plurality of first columns in the first gas diffusion portion so as to permit the first plate to be connected to the second plate, forming a plurality of second columns in the second gas diffusion portion so as to permit the second plate to be connected to the third plate, carrying out the heat transmission between the first plate and the second plate through the first columns; and carrying out the heat transmission between the second plate and the third plate through the second columns.

Further, according to a seventh aspect of the present invention, there is provided a heat radiation method of the process gas discharging mechanism included in a gas processing device comprising a process chamber accommodating a target substrate, a mounting table arranged in the process chamber for mounting the target substrate, a process gas discharging mechanism arranged in a position to face the target substrate disposed on the mounting table for discharging first and second process gases into the process chamber, and an exhaust mechanism for exhausting the process chamber, wherein the process gas discharging mechanism includes a gas introducing portion for introducing first and second process gases into the process gas discharging mechanism, a gas discharging portion provided with a plurality of first and second gas discharging holes for discharging each of the first and second process gases toward the mounting table, and first and second flat gas diffusion portions stacked one upon the other in the region between the gas introducing portion and the gas discharging portion, the method comprising forming a plurality of first columns in the first gas diffusion portion and a plurality of second columns each including a gas flowing hole for flowing the first process gas in the second gas diffusion portion, and carrying out the heat transmission between the gas discharging portion and the gas introducing portion through the first and second columns, thereby dissipating the heat from the process gas discharging mechanism.

According to the first, second, third, fifth, sixth and seventh aspects of the present invention, in the process gas discharging mechanism receiving the radiation heat from the mounting table serving to heat the target substrate, heat transfer columns (column bodies) for performing the heat transmission are arranged in the gas diffusion portion, which consisted of a flat large space in the prior art, and, thus, the heat transmission can be performed sufficiently in the thickness direction of the process gas discharging mechanism, thereby making it possible to improve the heat dissipating efficiency. As a result, the radiation heat emitted from the mounting table and received by the process gas discharging mechanism arranged to face the mounting table can be dissipated efficiently toward the back side in the thickness direction of the process gas discharging mechanism to make it possible to suppress without fail the temperature rise of, for example, the gas supply pipes connected to the process gas discharging mechanism.

As a result, where a film is formed on the target substrate by the thermal decomposition of the process gas supplied from the process gas discharging mechanism onto the target substrate supported by the mounting table, it is possible to maintain the temperature of the process gas discharging mechanism at a level not higher than the thermal decomposition temperature of the raw material gas without fail. It follows that it is possible to prevent without fail the inconvenience that the raw material gas is thermally decomposed inside the process gas discharging mechanism or within the connecting pipe before the raw material gas is supplied to reach the target substrate. Naturally, it is possible to prevent without fail the thin film-forming rate from being lowered (to prevent the required film-forming time from being prolonged) and to prevent the nonuniformity in the film thickness and the film quality (composition ratio) from being generated by, for example, the decrease or nonuniformity in the concentration of the raw material gas. It is also possible to prevent without fail the generation of the film defect derived from the reaction product of the thermal decomposition reaction, which is attached to the inner region of the process gas discharging mechanism and scattered to be attached to the target substrate as a foreign matter.

It should also be noted that, since the heat transfer columns (column bodies) arranged in the present invention permit the heat to be transmitted sufficiently in the thickness direction of the process gas discharging mechanism, it is possible to control effectively the temperature in the lower portion of the process gas discharging mechanism because a temperature control mechanism is arranged in the present invention in the upper portion of the process gas discharging mechanism, though the temperature of the lower portion of the process gas discharging mechanism noted above tends to be risen easily upon receipt of the radiation heat from the mounting table. Such being the situation, the effect of the present invention can be produced effectively.

Further, since the heat transfer columns (column bodies) are arranged in the gas diffusion portion in the present invention, the gas diffusion space is held continuous, though the gas diffusion space is separated in the case of arranging a partition wall. Since the gas diffusion space is held continuous, the gas can be diffused uniform within the gas diffusion space and, thus, can be moved downward uniformly. In addition, it is unnecessary complication arrangement of a gas pipe (gas flowing passageway) for supplying a gas into the gas diffusion space by branching the gas pipe in every separated gas diffusion space, with the result that the gas pipe can be shortened and simplified.

Also, according to the fourth aspect of the present invention, the temperature control mechanism for controlling the temperature of the process gas discharging mechanism has a heat dissipating mechanism for dissipating the heat transmitted from the lower portion of the process gas introducing portion through the heat transfer columns so as to make it possible to dissipate effectively the heat of the process gas discharging mechanism and, thus, to control uniform the temperature of the process gas discharging mechanism. It follows that it is possible to suppress the temperature rise with time, thereby performing the temperature control with a high accuracy.

### Brief Description of Drawings

[FIG. 1] FIG. 1 is a cross sectional view showing the construction of a film-forming apparatus according to a first embodiment of the present invention;
[FIG. 2] FIG. 2 is a perspective plan view exemplifying the construction of the bottom portion of the housing of the film-forming apparatus according to the first embodiment of the present invention;
[FIG. 3] FIG. 3 is a plan view showing the construction of the housing of the film-forming apparatus according to the first embodiment of the present invention;
[FIG. 4] FIG. 4 is a plan view showing the construction of a shower base of a shower head included in the film-forming apparatus according to the first embodiment of the present invention;
[FIG. 5] FIG. 5 is a bottom view showing the construction of the shower base of the shower head included in the film-forming apparatus according to the first embodiment of the present invention;
[FIG. 6] FIG. 6 is a plan view showing the construction of the gas diffusing plate of the shower head included in the film-forming apparatus according to the first embodiment of the present invention;
[FIG. 7] FIG. 7 is a bottom view showing the construction of the gas diffusing plate of the shower head included in the film-forming apparatus according to the first embodiment of the present invention;
[FIG. 8] FIG. 8 is a plan view showing the construction of a shower plate of the shower head included in the film-forming apparatus according to the first embodiment of the present invention;
[FIG. 9] FIG. 9 is a cross sectional view showing the construction of the shower base along the line IX-IX shown in FIG. 4;
[FIG. 10] FIG. 10 is a cross sectional view showing the construction of the diffusion plate along the line X-X shown in FIG. 6;
[FIG. 11] FIG. 11 is a cross sectional view showing the construction of the shower plate along the line XI-XI shown in FIG. 8;
[FIG. 12] FIG. 12 shows in a magnified fashion the arrangement of heat transfer columns;
[FIG. 13] FIG. 13 shows another example of the heat transfer columns;
[FIG. 14] FIG. 14 shows another example of the heat transfer columns;
[FIG. 15] FIG. 15 shows still another example of the heat transfer columns;
[FIG. 16] FIG. 16 is a view for explaining a simulation for confirming the influence given by the height of the vertical section of the gas pipe to the uniformity of the gas diffusion;
[FIG. 17] FIG. 17 is a graph showing the result of the simulation for confirming the influence given by the height of the vertical section of the gas pipe to the uniformity of the gas diffusion;
[FIG. 18] FIG. 18 is a conceptual diagram showing the construction of the gas supply source included in the film-forming apparatus according to the first embodiment of the present invention;
[FIG. 19] FIG. 19 is a graph exemplifying the effect produced by the film-forming apparatus according to the first embodiment of the present invention;
[FIG. 20] FIG. 20 is a graph exemplifying the effect produced by the film-forming apparatus according to the first embodiment of the present invention;
[FIG. 21] FIG. 21 shows the temperature-measuring points of the shower head included in the film-forming apparatus according to the first embodiment of the present invention;
[FIG. 22] FIG. 22 is a cross sectional view showing the construction of a film-forming apparatus according to a second embodiment of the present invention;
[FIG. 23] FIG. 23 is a plan view showing the construction of the film-forming apparatus according to the second embodiment of the present invention;
[FIG. 24] FIG. 24 is a graph showing the effect produced by the second embodiment of the present invention;
[FIG. 25] FIG. 25 is a cross sectional view showing the construction of a shower head included in a film-forming apparatus according to a third embodiment of the present invention;

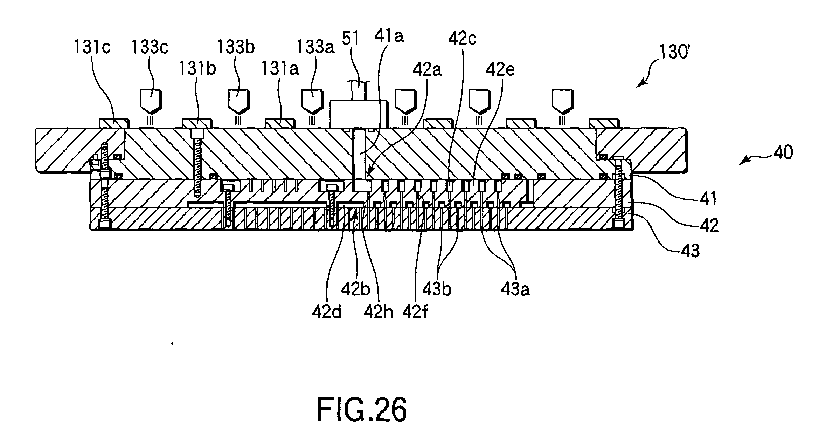

[FIG. 26] FIG. 26 is a cross sectional view showing a modification of the shower head included in the film-forming apparatus according to the third embodiment of the present invention;
[FIG. 27] FIG. 27 is a cross sectional view showing another modification of the shower head included in the film-forming apparatus according to the third embodiment of the present invention;
[FIG. 28] FIG. 28 is a plan view exemplifying the zone division in performing the zone control of the temperature control section shown in FIG. 25;
[FIG. 29] FIG. 29 is a cross sectional view showing the construction of a shower head included in a film-forming apparatus according to a fourth embodiment of the present invention;
[FIG. 30] FIG. 30 is a cross sectional view showing the construction of a shower head included in a film-forming apparatus according to a fifth embodiment of the present invention;
[FIG. 31] FIG. 31 is a plan view showing the construction of the shower head included in a film-forming apparatus according to the fifth embodiment of the present invention;
[FIG. 32A] FIG. 32A is a plan view showing a modification of the temperature control mechanism used in the shower head included in the film-forming apparatus according to the fifth embodiment of the present invention;
[FIG. 32B] FIG. 32B is a cross sectional view showing a modification of the temperature control mechanism used in the shower head included in the film-forming apparatus according to the fifth embodiment of the present invention;
[FIG. 33] FIG. 33 is a cross sectional view showing the construction of a shower head included in a film-forming apparatus according to a sixth embodiment of the present invention;
[FIG. 34] FIG. 34 is a cross sectional view showing the construction of a shower head included in a film-forming apparatus according to a seventh embodiment of the present invention; and
[FIG. 35] FIG. 35 is a cross sectional view showing a modification of the temperature control mechanism used in the shower head included in the film-forming apparatus according to the seventh embodiment of the present invention.

### Best Mode for Carrying Out the Invention

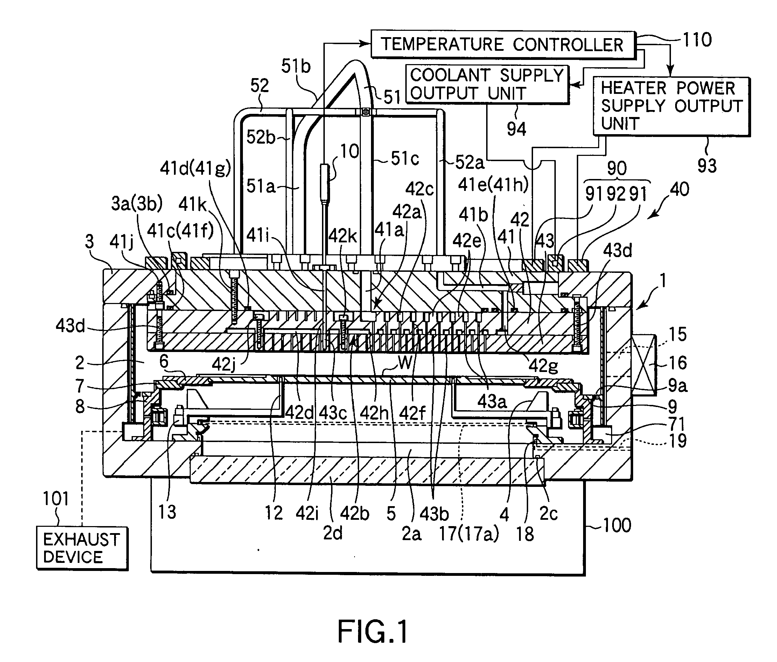

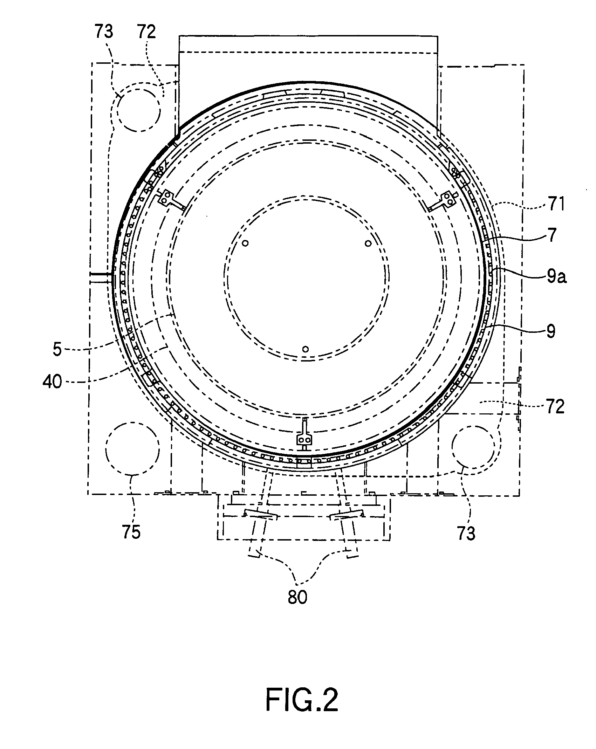

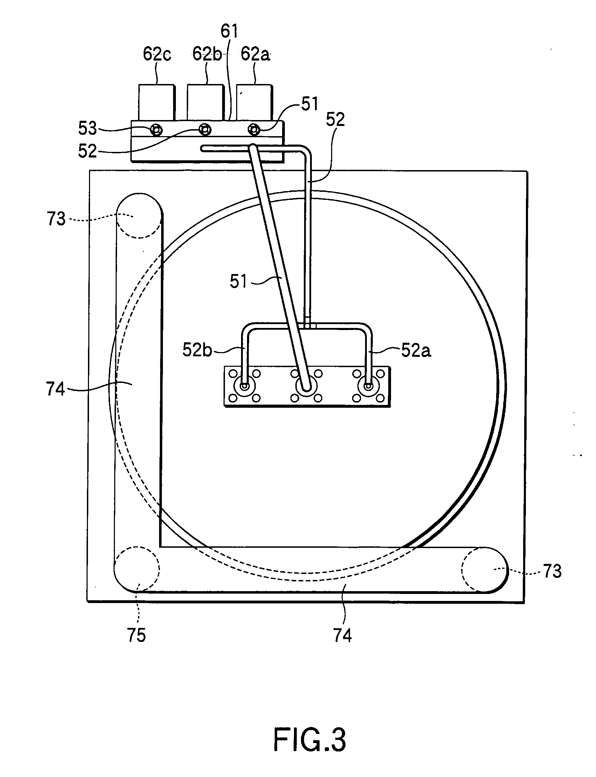

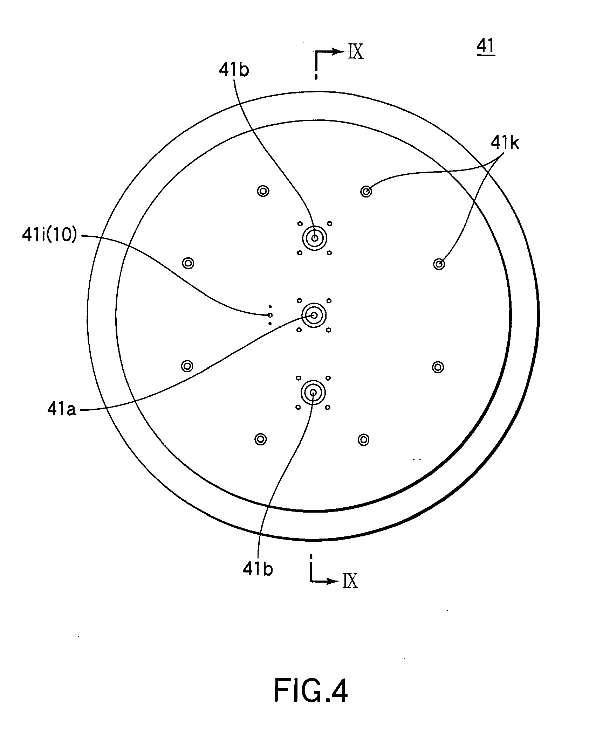

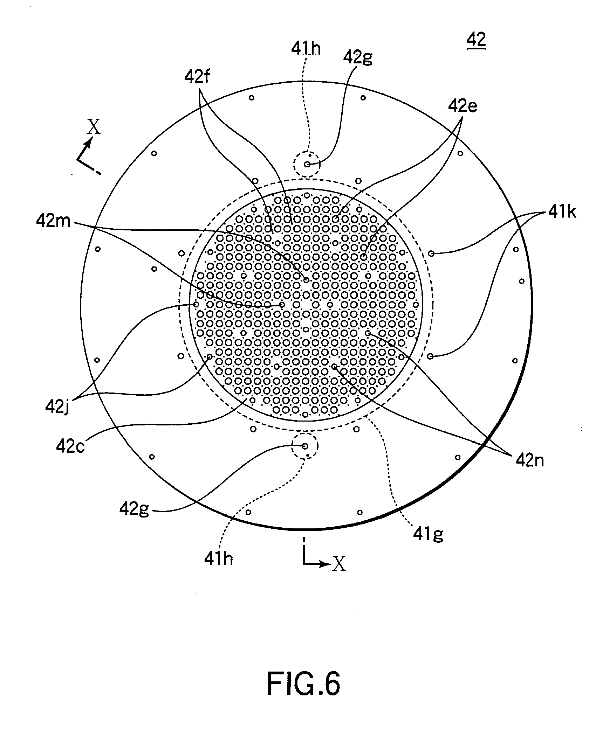

Some embodiments of the present invention will now be described in detail with reference to the accompanying drawings.
[First Embodiment]
A first embodiment of the present invention will now be described first. FIG. 1 is a cross sectional view showing the construction of the film-forming apparatus according to a first embodiment of the present invention, FIG. 2 is a plan view showing the inner construction of the housing of the film-forming apparatus according to the first embodiment of the present invention, and FIG. 3 is a plan view showing the upper portion of the housing included in the film-forming apparatus according to the first embodiment of the present invention. Also, FIGS. 4 to 11 show the constituting parts of the shower head included in the film-forming apparatus according to the first embodiment of the present invention.
Incidentally, FIG. 1 is a cross sectional view of the shower head along the line X-X shown in FIG. 6 referred to herein later. It should be noted that the left portion and the right portion of FIG. 1 relative to the central portion are asymmetric.

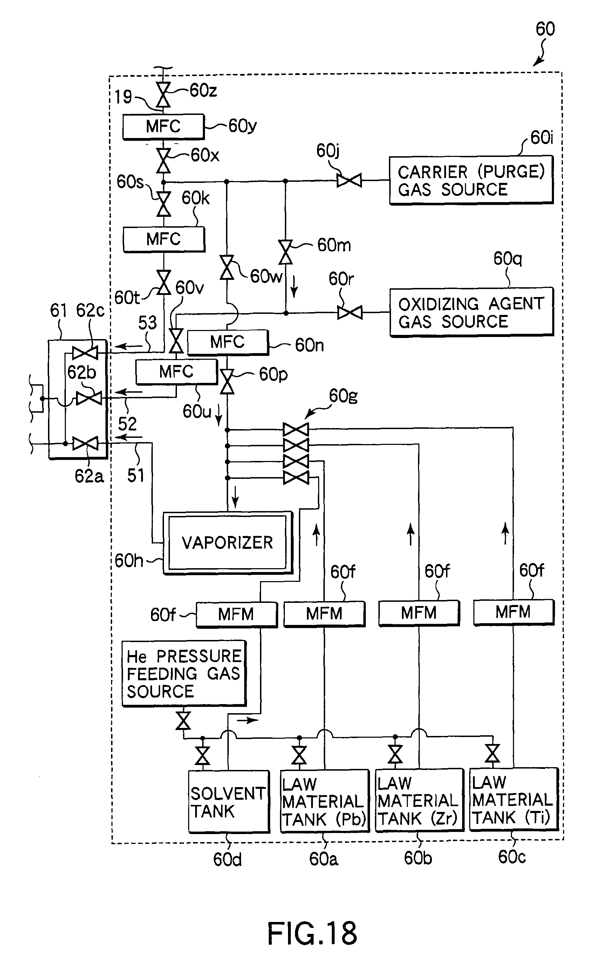

As shown in FIG. 1, the film-forming apparatus according to the first embodiment of the present invention comprises a housing 1 formed of, for example, aluminum and having a substantially rectangular planar cross section. The inner region of the housing 1 constitutes a cylindrical process chamber 2. An opening 2a to which is connected a lamp unit 100 is formed in the bottom portion of the process chamber 2. A transmitting window 2d formed of quartz is attached to the opening 2a by using a sealing member 2c consisting of an O-ring so as to hermetically seal the process chamber 2. A lid 3 that can be opened is mounted to the upper portion of the process chamber 2, and a shower head 40 constituting a gas discharging mechanism is mounted so as to be supported by the lid 3. The construction of the shower head 40 will be described herein later in detail. Also, a gas supply source 60 (see FIG. 18) for supplying various gases into the process chamber 2 through the shower head 40 is arranged behind the shower head 40. Further, a raw material gas pipe 51 for supplying the raw material gas and an oxidizing agent gas pipe 52 for supplying an oxidizing agent gas are connected to the gas supply source 60. The oxidizing agent gas pipe 52 is branched into oxidizing agent gas branched pipes 52a and 52b. Naturally, the raw material gas pipe 51 and the oxidizing agent gas branched pipes 52a, 52b are connected to the shower head 40.

A cylindrical shield base 8, which is erected from the bottom portion of the process chamber 2, is arranged inside the process chamber 2. An annular base ring 7 is arranged in the opening in the upper portion of the shield base 8, and an annular attachment 6 is , supported on the inner circumferential side of the base ring 7. A mounting table 5 for supporting a wafer W is supported by the stepped portion on the inner circumferential side of the attachment 6. Also, a baffle plate 9, which is described herein later, is arranged on the outside of the shield base 8.

A plurality of exhaust ports 9a are formed in the baffle plate 9. A bottom portion exhaust passage 71 is formed in a manner to surround the shield base 8 in the outer circumferential bottom portion of the process chamber 2. Since the inner region of the process chamber 2 is allowed to communicate with the bottom portion exhaust passage 71 via the exhaust ports 9a of the baffle plate 9, the gaseous material within the process chamber 2 can be discharged uniformly. An exhaust apparatus 101 for discharging the gaseous material from within the process chamber 2 is arranged below the housing 1. The exhausting operation performed by the exhaust apparatus 101 will be described herein later in detail.

The lid 3 is arranged in a manner to close the opening in the upper portion of the process chamber 2. Also, the shower head 40 is arranged in that portion of the lid 3 which is positioned to face the wafer W disposed on the mounting table 5.

A cylindrical reflector 4 is erected from the bottom portion of the process chamber 2 within the space surrounded by the mounting table 5, the attachment 6, the base ring 7 and the shield base 8. The reflector 4 reflects the heat rays radiated from the lamp unit (not shown) so as to guide the heat rays to the lower surface of the mounting table 5, with the result that the mounting table 5 efficiently performs the heating function. It should be noted that the heat source is not limited to the lamp referred to above. Alternatively, it is also possible to bury a resistance heating body in the mounting table 5 so as to heat the mounting table 5.

The reflector 4 is provided with slit portions in, for example, three points, and lift pins 12 for moving upward the wafer W from the mounting table 5 are arranged in the positions corresponding to the slit portions of the reflector 4. Each of these lift pins 12 is arranged movable in the vertical direction. The lift pin 12, which consists of a pin portion and an indicating portion that are formed integral, is supported by an annular holding member 13 arranged outside the reflector 4 and moved up and down by moving up and down the holding member 13 by operating an actuator (not shown). The lift pin 12 is formed of a material that permits transmitting the heat rays radiated from the lamp unit. For example, the lift pin 12 is formed of quarts or a ceramic material such as Al₂O₃, AlN or SiC.

When the wafer W is transferred, the lift pins 12 are moved upward by a prescribed distance from the mounting table 5, and when the wafer W supported by the lift pins 12 is delivered onto the mounting table 5, the lift pins 12 are moved downward into the mounting table 5.

The reflector 4 is arranged in the bottom portion of the process chamber 2 right below the mounting table 5 such that the reflector 4 surrounds the opening 2a in the bottom portion of the process chamber 2. Also, a gas shield plate 17 formed of a material capable of transmitting the heat rays such as quarts is arranged in the inner circumferential region of the reflector 4 such that the entire circumferential region of the gas shield plate 17 is supported by the reflector 4. A plurality of holes 17a are formed in the gas shield plate 17.

Also, a purge gas (for example, an inert gas such as a N₂ gas or an Ar gas etc.) is supplied from a purge gas supply mechanism into the space between the gas shield plate 17 supported by the inner circumferential region of the reflector 4 and the transmitting window 2d formed below the gas shield plate 17 through a purge gas passage 19 formed in the bottom portion of the process chamber 2 and gas discharging ports 18 equidistantly arranged in 8 points in the lower portion inside the reflector 4.

The purge gas thus supplied is allowed to flow toward the back side of the mounting table 5 through the plural holes 17a of the gas shield plate 17, thereby to prevent the process gas and the cleaning gas supplied from the shower head 40 described herein later from entering the space on the back side of the mounting table 5. As a result, it is possible to prevent the deposition of the thin film on the transmitting window 2d and to prevent the damage done by etching.

A wafer transfer port 15 communicating with the process chamber 2 is formed in the side wall of the housing 1. The wafer transfer port 15 is connected to a load lock chamber (not shown) via a gate valve 16.

As exemplified in FIG. 2, an annular bottom portion exhaust passage 71 communicates with exhaust combining portions 72 arranged in symmetry in the diagonal positions in the bottom portion of the housing 1 in a manner to have the process chamber 2 sandwiched therebetween. The exhaust combining sections 72 are connected to a down stream exhaust passage 75 arranged to extend through the corner portions of the housing 1 via an upstream exhaust passage 73 formed in a corner portion of the housing 1 and via a lateral exhaust pipe 74 formed in the upper portion of the housing 1 so as to be connected to the exhaust device 101 (see FIG. 1) arranged below the housing 1. Since the upstream exhaust passage 73 and the downstream exhaust passage 75 are arranged by utilizing the space in the corner portions of the housing 1, the exhaust passage can be formed within the foot print of the housing 1. It follows that the installing foot print of the apparatus is not increased so as to make it possible to diminish the installing space of the thin film-forming apparatus.

Incidentally, a plurality of thermocouples 80 (see FIG. 2) are inserted into the mounting table 5. For example, a first thermocouple 80 is inserted into the central portion of the mounting table 5 and another thermocouple 80 is inserted into an edge portion of the mounting table 5. As a result, the temperature of the mounting table 5 is measured by these thermocouples 80, and the temperature of the mounting table 5 is controlled on the basis of the temperature measurement performed by these thermocouples 80.

The shower head 40 will now be described in detail.
The shower head 40 comprises a cylindrical shower base (first plate) 41 that is formed such that the outer edge of the shower base 41 is engaged with the upper portion of the lid 3, a cylindrical gas diffusion plate (second plate) 42 that is formed in tight contact with the lower surface of the shower base 41, and a shower plate (third plate) 43 mounted to the lower surface of the gas diffusion plate 42. The uppermost shower base 41 included in the shower head 40 is constructed to permit the heat of the entire shower head 40 to be dissipated to the outside. The drawings suggest that the shower head 40 as a whole has a columnar configuration having a circular cross section. However, it is also possible for the shower head 40 to be in the shape of a column having a rectangular cross section.

The shower base 41 is fixed to the lid 3 via a base-fixing screw 41j. Also, a lid O-ring groove 3a and a lid O-ring 3b are arranged in the coupling portion between the shower base 41 and the lid 3 so as to permit the shower base 41 and the lid 3 to be hermetically coupled with each other.

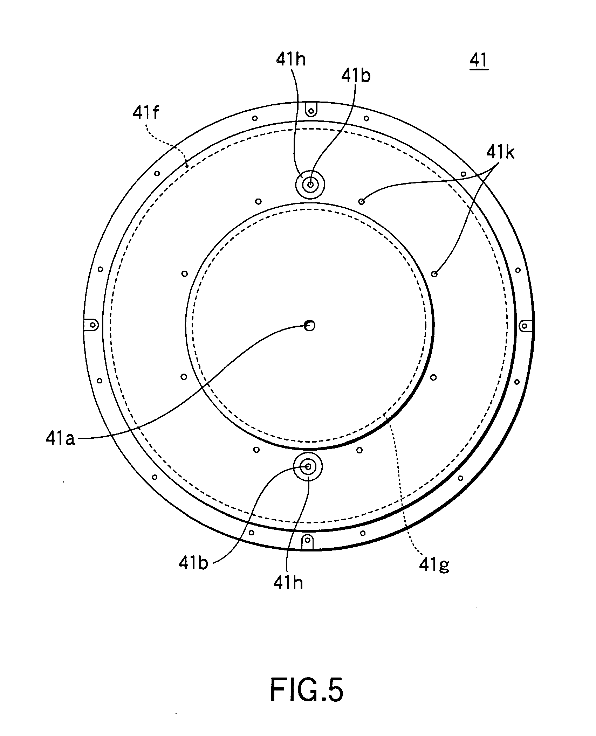

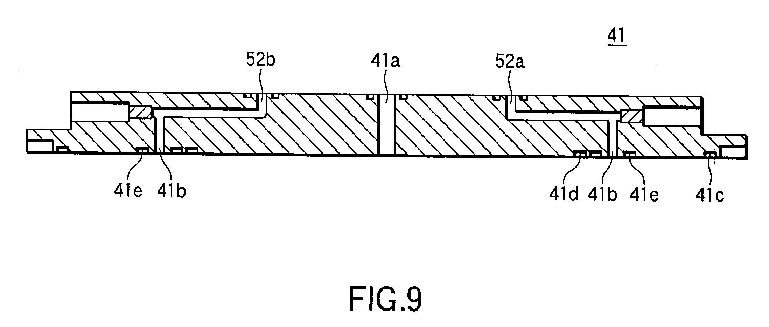

FIG. 4 is a plan view showing the upper portion of the shower base 41, FIG. 5 is a plan view showing the lower portion of the shower base 41, and FIG. 9 is a cross sectional view along the line IX-IX shown in FIG. 4. As shown in the drawings, the shower base 41 includes a first gas introducing passage 41a arranged in the central portion and having the raw material gas pipe 51 connected thereto and a plurality of second gas introducing passages 41b to which are connected the oxidizing agent gas branched pipes 52a and 52b of the oxidizing agent gas pipe 52. The first gas introducing passage 41a extends upright in a manner to extend through the shower base 41. Also, the second gas introducing passage 41b is hook-shaped such that the passage 41b extends downward from the gas introducing section to reach the inner region of the shower base 41 and, then, extends in a horizontal direction and, further extends downward. FIG. 1 shows that the oxidizing agent gas branched pipes 52a and 52b are arranged in symmetry in a manner to have the first gas introducing passage 41a sandwiched therebetween. However, it is possible to arrange the oxidizing agent gas branched pipes 52a and 52b anywhere desired as far as it is possible to supply the oxidizing agent gas uniformly.

An outer circumferential O-ring groove 41c and an inner circumferential O-ring groove 41d are formed on the lower surface of the shower base 41 at which the shower base 41 is bonded to the gas diffusion plate 42. An outer circumferential O-ring 41f and an inner circumferential O-ring 41g are mounted to these O-ring grooves 41c and 41d, respectively, so as to maintain a hermetic bonding surface between the shower base 41 and the gas diffusion plate 42. Also, an O-ring groove 41e for the gas passage and an O-ring 41h for the gas passage are formed in the open section of the second gas introducing passage 41b. As a result, the raw material gas and the oxidizing agent gas are prevented without fail from being mixed with each other.

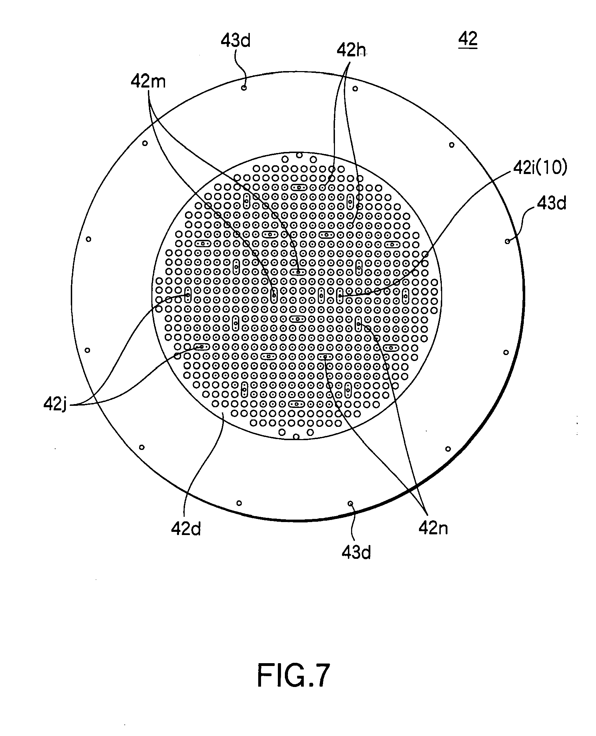

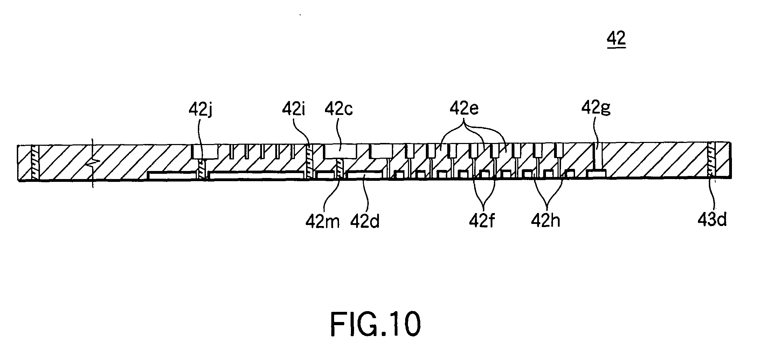

The gas diffusion plate 42 having a gas passage is arranged in contact with the lower surface of the shower base 41. FIG. 6 is a plan view showing the upper side of the gas diffusion plate 42, FIG. 7 is a plan view showing the lower side of the gas diffusion plate 42, and FIG. 10 is a cross sectional view along the line X-X shown in FIG. 6. As shown in the drawings, a first gas diffusion section 42a and a second gas diffusion section 42b are formed on the upper surface side and on the lower surface side of the gas diffusion plate 42, respectively.

The first gas diffusion portion 42a on the upper side of the gas diffusion plate 42 includes a plurality of columnar projections forming heat transfer columns 42e that are formed in a manner to avoid the open positions of the first gas passages 42f, and the space portion other than the heat transfer columns 42e constitutes a first gas diffusion space 42c. The height of the heat transfer column 42e is set substantially equal to the depth of the first gas diffusion portion 42a. Since the heat transfer column 42e is in contact with the shower base 41 positioned on the upper side, the heat transfer column 42e performs the function of transmitting the heat generated from the shower plate 43 on the lower side to the shower base 41.

The second gas diffusion section 42b on the lower side of the gas diffusion plate 42 includes a plurality of columnar projections 42h, and the space other than the columnar projections 42h constitutes a second gas diffusion space 42d. The second gas diffusion space 42d extends through a second gas passage 42g formed in a manner to extend vertically through the gas diffusion plate 42 so as to communicate with the second gas introducing passage 41b of the shower base 41. First gas passages 42f are formed to extend through the central portion of some columnar projections 42h. The region in which the first gas passages 42f are formed corresponds to or more the region of the target object to be processed or, preferably, is larger than the region of the target object by 10% or more. The height of the columnar projection 42h is set substantially equal to the depth of the second gas diffusion section 42b, and the columnar projection 42h is in contact with the upper surface of the shower plate 43 that is in contact with the lower surface of the gas diffusion plate 42. Incidentally, some of the columnar projections 42h in which is formed the first gas passage 42f are arranged to permit a first gas discharge hole 43a, which is described herein later, of the shower plate 43 attached to the lower side of the gas diffusion plate 42 to communicate with the first gas passage 42f. Also, it is possible for the first gas passage 42f to be formed in all of the columnar projections 42h.

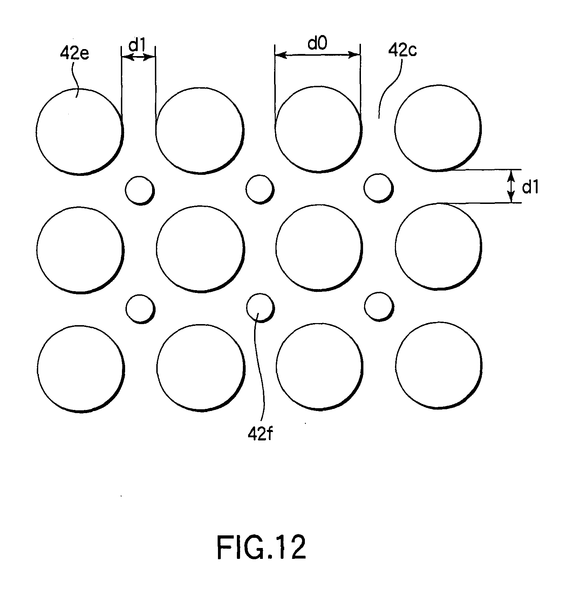

As shown in a magnified fashion in FIG. 12, the diameter d0 of the heat transfer column 42e is set at, for example, 2 to 20 mm, preferably at 5 to 12 mm. Also, the distance d1 between the adjacent heat transfer columns 42e is set at 2 to 20 mm, preferably, at 2 to 10 mm. It is desirable for the heat transfer columns 42e to be arranged to permit the area ratio R, which is S1/S2, i.e., the ratio R of the sum S1 of the cross sectional areas of the plural heat transfer columns 42e to the cross sectional area S2 of the first gas diffusion portion 42a, to fall within a range of 0.05 to 0.50. If the area ratio R is smaller than 0.05, the effect of improving the efficiency of transmitting the heat to the shower base 41 is diminished to adversely affect the heat dissipating properties. By contraries, if the area ratio R is larger than 0.50, the flow resistance of the gas in the first gas diffusion space 42c is increased to bring about a nonuniformity in the gas flow. As a result, the nonuniformity of the film thickness in a plane tends to be increased when a film is formed on the substrate. Further, in the first embodiment of the present invention, the first gas passages 42f and the heat transfer columns 42e are arranged to permit the distance between the first gas passage 42f and the adjacent heat transfer column 42e to be made constant. However, it is possible for the heat transfer columns 42e and the first gas passages 42f to be arranged optionally as far as the heat transfer column 42 is positioned between the adjacent first gas passages 42f regardless of the arrangement shown in FIG. 12.

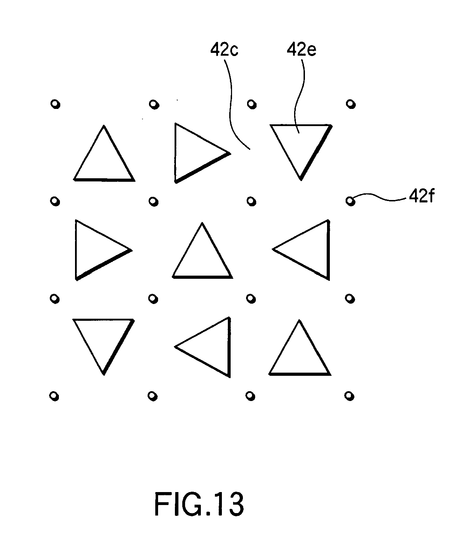

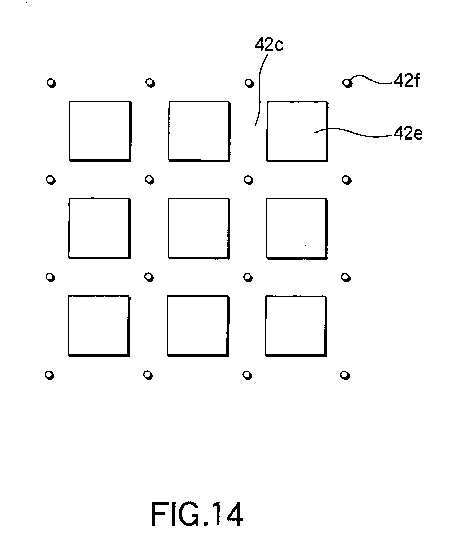

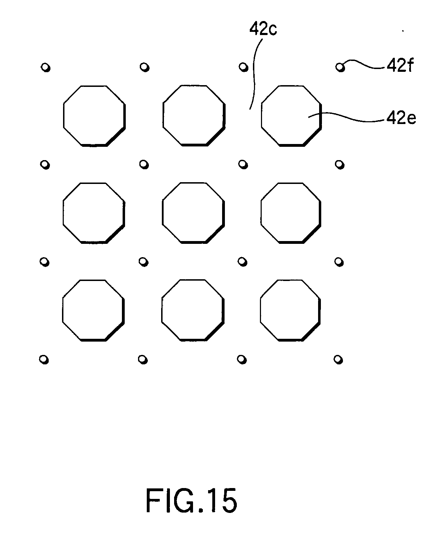

Also, the heat transfer column 42e has a circular cross section in the example shown in FIG. 12.
However, it is also possible for the heat transfer column 42e to have a triangular cross section as shown in FIG. 13, to have a square cross section as shown in FIG. 14, or to have a polygonal cross section such as an octagonal cross section as shown in FIG. 15, though it is desirable for the heat transfer column 42e to have a smooth spherical surface such that the column 42e has an elliptical cross section as well as the circular cross section as shown in FIG. 12 because the column 42e having a spherical surface permits suppressing the flow resistance of the gas.

Further, it is desirable for the heat transfer columns 42e to be arranged to form a lattice or a stagger. It is also desirable for the first gas passages 42f to be formed in the centers of the region between heat transfer columns 42e that are arranged to form a lattice or a stagger. For example, where the heat transfer column 42e has a circular cross section, the area ratio R noted above is 0.44 if the heat transfer columns 42e each having a diameter d0 of 0.8 mm are arranged to form a lattice in a manner to have 1.2 mm of the distance d1 noted above. If the heat transfer columns 42e are sized and arranged as above, it is possible to maintain a high heat transmitting efficiency and a high uniformity of the gas flow. Incidentally, it is possible to set appropriately the area ratio R in accordance with the kind of the gas used.

Also, a plurality of diffusion plate fixing screws 41k are arranged in a plurality of points in the vicinity of the peripheral portion of the first gas diffusion portion 42a, i.e., in the vicinity of the outer side of the inner circumferential O-ring groove 41d, for fixing the upper edge portion of the heat transfer column 42e within the first gas diffusion section 42a to the lower surface of the shower base 41. By the fastening force of the diffusion plate fixing screw 41k, a plurality of the heat transfer columns 42e within the first gas diffusion section 42a are fixed without fail to the lower surface of the shower base 41 so as to decrease the resistance to the heat transmission, with the result that the heat transfer column 42e is allowed to produce the heat transmitting effect without fail. It is possible for the fixing screw 41k to be mounted to the heat transfer column 42e of the first gas diffusion portion 42a.

A plurality of heat transfer columns 42e arranged within the first gas diffusion portion 42a do not partition the channel unlike the partition wall. As a result, the first gas diffusion space 42c is not separated but is formed continuous. It follows that the gas introduced into the first gas diffusion space 42c can be moved downward in the state of being diffused over the entire region.

Also, according to the studies conducted by the present inventors, the gas diffusion capability of the gas diffusion space is dependent on the length in the vertical section of the gas pipe for introducing a gas into the shower head. To be more specific, it has been clarified that, if the vertical section of the gas pipe is sufficiently long, the gas is prevented from being unevenly distributed in the gas introducing section by the inertia or by the change in the flowing direction of the gas, thereby permitting the gas to be diffused uniformly within the gas diffusion space. On the other hand, if the vertical section of the gas pipe is short, the gas is supplied in an oblique direction into the gas diffusion space, thereby causing the pressure distribution of the gas to be uneven inside the gas introducing section by the inertia of the gas and by the fluctuation of the gas pressure caused by the change in the flowing direction of the gas. Particularly, in the case of the raw material gas, the uniformity of the film-forming processing is impaired by the unevenness of the pressure distribution of the gas. The unevenness of the gas pressure distribution is rendered prominent with increase in the specific gravity of the gas used.

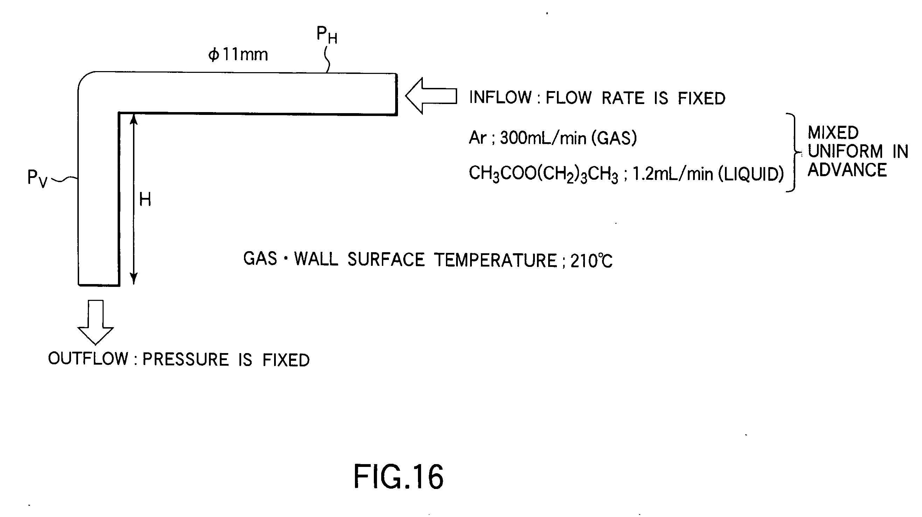

A simulation was performed in respect of the relationship between the length of the vertical section of the pipe for introducing a gas and the velocity distribution of the gas introduced from the gas introducing section. In this simulation, the steady calculation of the gas flow was used as a calculation model, and the simulation was performed by bending a pipe at 90° so as to have a horizontal section P_{H} and a vertical section Pᵥ as shown in FIG. 16. The calculation was performed under the conditions that the pipe diameter was set at 11 mm *φ*, the temperature of the gas and the pipe wall surface was set at 210°C, the gas flowing into the pipe was prepared in advance by uniformly mixing an Ar gas, which is an inert gas, with a butyl acetate gas, which is a gas of an organic compound, the Ar gas flow rate at the inflow edge was set at a fixed value of 300 mL/min (gas), the flow rate of the butyl acetate gas was set at a fixed value of 1.2 mL/min (liquid), the pressure at the outflow side of the pipe was set at a fixed value of 319.2 Pa (2.4 Torr), and the height H of the vertical section Pᵥ of the pipe was changed so as to be set at 46 mm, 92 mm or 138 mm. Incidentally, the pressure on the outflow side was estimated from the formula of Hagen-Poiseuille, which is a formula for determining the pressure loss.

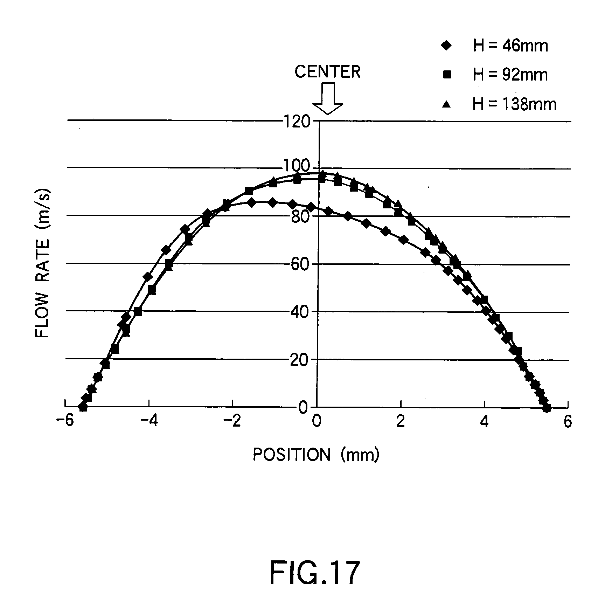

FIG. 17 shows the result. FIG. 17 is a graph showing the relationship between the length of the vertical section of the pipe and the flowing speed of the gas, wherein the position in the radial direction within the pipe is plotted on the abscissa and the flowing speed of the gas is plotted on the ordinate.
As apparent from the graph of FIG. 17, the flowing speed distribution of the gas is uneven in the case where the height H is small, i.e., 46 mm. However, the flowing speed distribution is made uniform with increase of the height H to 92 mm and, then, to 138 mm. Where the height H of the vertical section Pᵥ is set at 138 mm, the fluctuation of the gas supply amount was smaller than 2% even if the gas flow rate was changed within a range of 50 to 500% so as to realize a uniformity of the gas supply and to increase the planar uniformity of the formed film.

Also, since the first gas diffusion space 42c is formed continuous as described previously, it is possible to introduce the raw material gas into the first gas diffusion space 42c through the first gas introducing route 41a and the raw material gas pipe 51 to make it possible to decrease the connecting points of the raw material gas pipe 51 to the shower head 40 and to simplify (shorten) the pathway for supplying the raw material gas into the first gas diffusion space 42c. Since the pathway of the raw material gas pipe 51 can be shortened, it is possible to increase the accuracy of the control for supplying the raw material gas from the gas supply source 60 into the first gas diffusion space 42c through a pipe panel 61 and for stopping the supply of the raw material gas. In addition, it is possible to decrease the installing space of the entire apparatus.

As shown in FIG. 1, the raw material gas pipe 51 is formed as a whole in the shape of an arch, and includes a vertically rising part 51a in which the raw material gas is moved vertically upward, an obliquely rising part 51b contiguous to the vertically rising part 51a, and a falling part 51c contiguous to the obliquely rising part 51b. Each of the connecting part between the vertically rising part 51a and the obliquely rising part 51b and the connecting part between the obliquely rising part 51b and the falling part 51c is moderately curved (large radius of curvature). As a result, it is possible to prevent the pressure fluctuation within the raw material gas pipe 51.

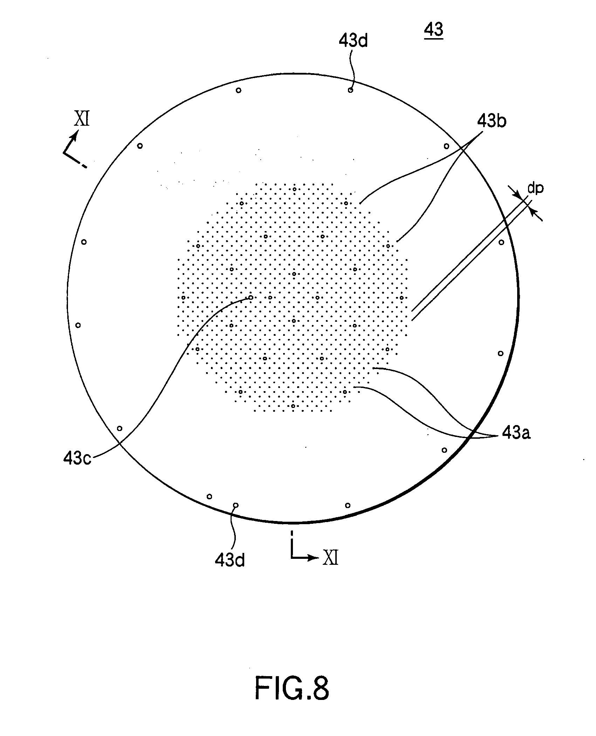

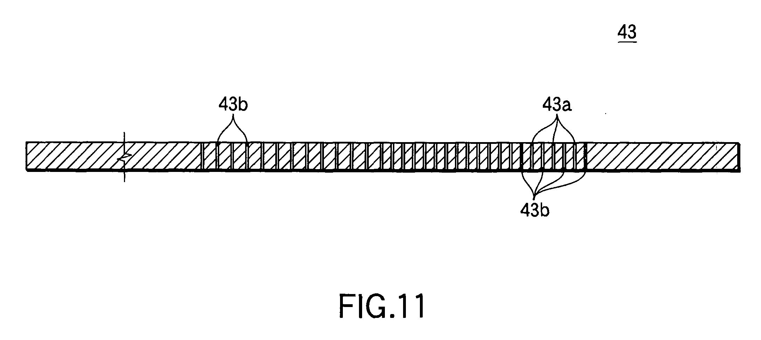

The shower plate 43 is fixed to the lower surface of the gas diffusion plate 42 described above via a plurality of fixing screws 42j, 42m and 42n, which are inserted from the upper surface of the gas diffusion plate 42 and arranged in the circumferential direction. These fixing screws are inserted from the upper surface of the gas diffusion plate 42 because, if the screw ridges or the screw grooves are formed on the surface of the shower plate 40, the film formed on the surface of the shower head 40 tends to be peeled off easily. The shower plate 43 will now be described. FIG. 8 is a plan view showing the upper side of the shower plate 43, and FIG. 11 is a cross sectional view along the line XI-XI shown in FIG. 8.

A plurality of first gas discharge holes 43a and a plurality of second gas discharge holes 43b are arranged so as to be positioned adjacent to each other on the shower plate 43. To be more specific, the plural first gas discharge holes 43a are arranged to communicate with a plurality of first gas passages 42f formed in the gas diffusion plate 42 on the upper side, and the plural second gas discharge holes 43b are arranged to communicate with the second gas diffusion space 42d included in the second gas diffusion section 42b formed in the gas diffusion plate 42 on the upper side. In other words, the second gas discharging holes 43b are arranged in the clearance among the plural columnar projections 42h.

In the shower plate 43, the plural second gas discharge holes 43b that are connected to the oxidizing agent gas pipe 52 are arranged in the outermost circumferential region, and first gas discharge holes 43a and the second gas discharge holes 43b are alternately arranged uniformly inside the second gas discharge holes connected to the oxidizing agent gas pipe 52. The first gas discharge holes 43a and the second gas discharge holes 43b are alternately arranged at a pitch "dp" of, for example, 7 mm. The first gas discharge holes 43a are formed at, for example, 460 points and the second gas discharge holes 43b are formed at, for example, 509 points. These arranging pitch "dp" and the number of each of the first gas discharge holes 43a and the second gas discharge holes 43b are determined appropriately in accordance with the size of the target object to be processed and the characteristics of film to be formed.

The shower plate 43, the gas diffusion plate 42 and the shower base 41, which collectively form the shower head 40, are fastened to each other by a plurality of fixing screws 43d for the stacking, which are arranged in the peripheral region.

Also, a thermocouple insertion hole 41i, a thermocouple insertion hole 42i, and a thermocouple insertion hole 43c, into which a thermocouple 10 is inserted, are formed in the overlapping portions in the thickness direction of the shower base 41, the gas diffusion plate 42 and the shower plate 43, which are stacked one upon the other, thereby making it possible to measure the temperature on the lower surface of the shower plate 43 and the inner region of the shower head 40. It is also possible to arrange the thermocouples 10 in the central portion and the outer peripheral region so as to control more uniformly and with a high accuracy the temperature on the lower surface of the shower plate 43. Since the substrate can be heated uniformly by the particular construction, it is possible to form a film having a planar uniformity.

A temperature control mechanism 90 comprising a plurality of annular heaters 91 divided into an outer side and an inner side and a coolant passage 92 arranged between the adjacent heaters 91 for circulating a coolant such as a cooling water is arranged on the upper surface the shower head 40. The detection signal of the thermocouple 10 is supplied into a temperature controller 110. Upon receipt of the detection signal, the temperature controller 110 supplies a control signal to a heater power supply output unit 93 and a coolant supply source output unit 94, thereby feeding the detection signal of the thermocouple 10 back to the temperature control mechanism 90. In this fashion, it is possible to control the temperature of the shower head 40.

A gas supply source 60 for supplying various gases into the reaction vessel 2 through the shower head 40 will now be described with reference to FIG. 18.

The gas supply source 60 comprises a vaporizer 60h for forming a raw material gas, a plurality of raw material tanks 60a to 60c for supplying a liquid raw material (organometallic compound) into the vaporizer 60h, and a solvent tank 60d. In the case of forming, for example, a thin film of PZT, Pb(thd)₂ is stored in the raw material tank 60a, Zr(OiPr)(thd)₃ is stored in the raw material tank 60b, and Ti(OiPr)₂(thd)₂ is stored in the raw material tank 60c as liquid raw materials, which are dissolved in the organic solvent in the vaporizer 60h and controlled at a predetermined temperature.
Also, CH₃COO (CH₂) ₃CH₃ is stored in the solvent tank 60d.

The plural raw material tanks 60a to 60c are connected to the vaporizer 60h via a flow meter 60f and a raw material supply control valve 60g. A carrier (purge) gas source 60i is connected to the vaporizer 60h via a purge gas supply control valve 60j, a flow rate control portion 60n and a mixing control valve 60p. In this fashion, each of the liquid raw materials is supplied into the vaporizer 60h.

The solvent tank 60d is connected to the vaporizer 60h via the flow rate meter 60f, and the raw material supply control valve 60g. A He gas used as a gas source that is compressed is introduced into each of the plural raw material tanks 60a to 60c and the solvent tank 60d so as permit the liquid raw materials and the solvent to be transferred by the pressure of the compressed He gas into the vaporizer 60h at a predetermined mixing ratio. The liquid raw materials and the solvent are evaporated within the vaporizer 60h so as to be transferred into the raw material gas pipe 51 as a raw material gas and, then, into the shower head 40 through a valve 62a arranged in a valve block 61.

Arranged in the gas supply source 60 is the carrier (purge) gas source 60i for supplying an inert gas such as Ar, He or N₂ into, for example, the purge gas passages 53 and 19 via the purge gas supply control valve 60g, a valve 60s, a valve 60x, the flow rate control portions 60k and 60y, a valve 60t and a valve 60z. Also arranged in the gas supply source 60 is the oxidizing agent gas source 60q for supplying an oxidizing agent (gas) such as NO₂, N₂O, O₂, O₃ or NO into the oxidizing agent gas pipe 52 via an oxidizing gas supply control valve 60r, a valve v, a flow rate control portion 60u, and a valve 62b formed in the valve block 61.

Under the state that the raw material supply control valve 60g is closed, a carrier gas is supplied from the carrier (purge) gas supply source 60i into the vaporizer 60h through the valve 60w, the flow rate control portion 60n and the mixing control valve 60p to make it possible to purge the undesired raw material gas within the vaporizer 60h including the inner region of the raw material gas pipe 51 with a carrier gas such as an Ar gas. Likewise, the carrier (purge) gas source 60i is connected to the oxidizing agent gas pipe 52 via a mixing control valve 60m so as to make it possible to purge the oxidizing gas and the carrier gas with a purge gas such as an Ar gas, if necessary. Further, the carrier (purge) gas source 60i is connected to the downstream side of the valve 62a of the raw material gas pipe 51 via the valve 60s, the flow rate control portion 60k, the valve 60t and a valve 62c arranged in the valve block 61 to make it possible to purge the downstream side of the raw material gas pipe 51 with a purge gas such as an Ar gas under the state that the valve 62 is closed.

The operation of the film-forming apparatus of the construction described above will now be described.
First, the process chamber 2 is evacuated by a vacuum pump (not shown) through an exhaust route extending through the bottom portion exhaust passage 71, the exhaust combining portion 72, the rising exhaust passage 73, the lateral exhaust pipe 74 and the downward exhaust passage 75, thereby setting the inner region of the process chamber 2 at a vacuum of about 100 to 550 Pa.

In this stage, a purge gas such as an Ar gas is supplied from the carrier (purge) gas source 60i into the purge gas passage 19 and is discharged from a plurality of gas discharging ports 18 onto the back surface (lower surface) side of the gas shield plate 17. Then, the purge gas flows into the back surface side of the mounting table 5 through the holes 17a formed in the gas shield 17 and flows further into the bottom portion exhaust passage 71 through the clearance between the back surface of the mounting table 5 and the shield base 8. In this fashion, formed is a steady purge gas stream serving to prevent the deposition of a thin film on the transmitting window 2d positioned below the gas shield plate 17 and to prevent the damage such as an etching.

In the process chamber 2 under the particular state, the lift pins 12 are moved upward by, for example, a robot hand mechanism (not shown) so as to be projected to a region above the mounting table 5, and the wafer W is transferred into the process chamber 2 via the gate valve 16 and the wafer transfer port 15. Further, the wafer W is disposed on the lift pins 12 by using, for example, a robot hand mechanism (not shown), followed by closing the gate valve 16.

Next, the lift pins 12 are moved downward so as to permit the wafer W to be disposed on the mounting table 5. At the same time, the lamp unit (not shown) is lit to irradiate the lower surface (back surface) of the mounting table 5 with the heat rays generated from the lamp unit and transmitted through the transmitting window 2d. As a result, the wafer W disposed on the mounting table 5 is heated to temperatures within a range of 450 to 700°C, e.g., heated to 500°C.

Raw material gases prepared by mixing, for example, Pd(thd)₂, Zr(OiPr)(thd)₃, and Ti(OiPr)₂(thd)₂ at prescribed mixing ratio such that the elements of Pb, Zr, Ti, O, etc. constituting PZT are mixed at prescribed stoichiometric ratio are supplied onto the wafer W thus heated through the plural first gas discharging holes 43a and the plural second gas discharging holes 43b formed in the shower plate 43 on the lower surface of the shower head 40. At the same time, an oxidizing agent gas such as a NO₂ gas is supplied onto the heated wafer W from the gas supply source 60. As a result, the thermal decomposition reaction of the raw material gas and the oxidizing agent gas and the chemical reaction among these gases are carried out on the heated wafer W, with the result that a thin film consisting of PZT is formed on the surface of the wafer W.

To be more specific, the evaporated raw material gas coming from the vaporizer 60h included in the gas supply source 60 is supplied together with the carrier gas from the raw material gas pipe 51 into a region above the wafer W through the first gas diffusion space 42c included in the gas diffusion plate 42, the first gas passage 42f, and the first gas discharging hole 43a formed in the shower plate 43. Likewise, the oxidizing agent gas supplied from the oxidizing gas supply source 60q is supplied into the second gas diffusion space 42d through the oxidizing gas pipe 52, the oxidizing gas branched pipe 52a, the second gas introducing passage 41b included in the shower base 41 and the second gas passage 42g formed in the gas diffusion plate 42 and, then, supplied into a region above the wafer W through the second gas discharging hole 43b formed in the shower plate 43. Each of the raw material gas and the oxidizing gas is supplied into the process chamber 2 so as not to be mixed with each other within the shower head 40. The supply time of the raw material gas and the oxidizing agent gas is controlled to control the thickness of the thin film formed on the wafer W.

In the conventional shower head, it is possible to control the temperature in the outer circumferential region of the shower head because a relatively satisfactory heat transmission can be performed in the outer circumferential region when the shower head receives the heat rays from the mounting table. However, a large space region is formed in the conventional shower head because a space is formed in substantially the entire region of that portion of the conventional shower head which corresponds to the first gas diffusion section 42a. As a result, the heat transmission cannot be performed sufficiently because of the heat insulating effect produced by the space to elevate the temperature. It follows that a temperature difference is formed on the surface of the shower head. Also, if the film-forming operation is carried out continuously, a problem is generated that the temperature elevation is rendered prominent in the central portion of the shower head.

In the first embodiment of the present invention, the radiation heat emitted from the mounting table 5 is transmitted to the shower plate 43. However, the heat received by the shower plate 43 is transmitted to reach the gas diffusion plate 42 through the plural columnar projections 42h mounted to the second gas diffusion section 42b included in the gas diffusion plate 42. Further, the heat received by the shower plate 43 is transmitted through the plural heat transfer columns 42e mounted to the first gas diffusion section 42a so as to reach the shower base 41. In other words, the transmitting efficiency of the heat from the shower plate 43 is becomes good to improve the heat dissipating effect such that the heat is efficiently transmitted to the central portion of the uppermost shower base 41 on the side of the air atmosphere to permit the heat to be dissipated from the shower base 41 into the air atmosphere. Such being the situation, the first embodiment of the present invention permits the temperature of the surface (lower surface) of the shower head 40 to be made lower that in the prior art even in the case where the mounting table 5 is heated to such a high temperature as 300 to 700°C as described previously. It should also be noted that, where the heat transfer columns are not used, the heat cannot be transmitted effectively into the inner region of the shower head 40 even if a temperature control mechanism is arranged on the upper surface of the shower head to make it substantially difficult to achieve a uniform temperature control. In the first embodiment of the present invention, however, the presence of the heat transfer columns 42e permits the temperature control mechanism 90 mounted to the upper surface of the shower head 40 to achieve a uniform temperature control of the shower head 40.

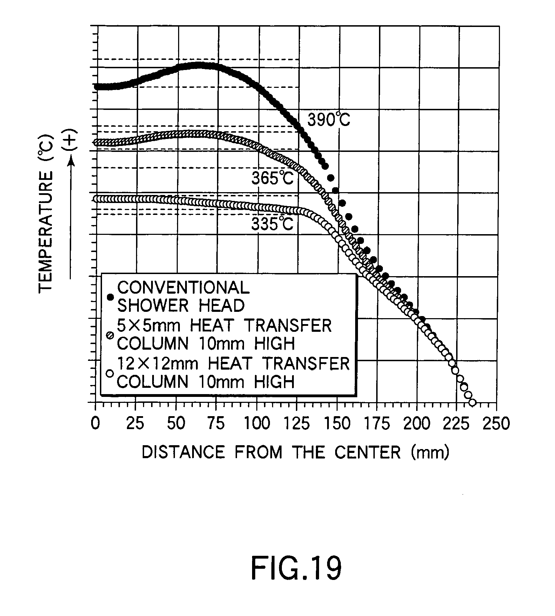

FIG. 19 shows the result of the simulation in respect of the temperature distribution of the shower head according to the first embodiment of the present invention, which comprises the heat transfer columns, and the conventional shower head having a gas diffusion space in the form of a cavity. The simulation was directed to the case where a wafer having a diameter of 200 mm was used as the substrate, and covered a conventional shower head having a gas diffusion space of cavity state, simulation model 1 for the first embodiment of the present invention in which were used heat transfer columns each having a rectangular cross section sized at 5 x 5 mm and having a height of 10 mm, and simulation model 2 for the first embodiment of the present invention in which were used heat transfer columns each having a rectangular cross section sized at 12 x 12 mm and having a height of 10 mm. As shown in FIG. 19, in the conventional shower head, the temperature of the entire shower head was elevated. In addition, the temperature distribution in the planar direction of the wafer was rendered nonuniform. On the other hand, in the simulation model 1 for the first embodiment of the present invention, the temperature of the shower head was made lower than that in the prior art and the uniformity of the temperature distribution was improved. Further, in the simulation model 2 for the first embodiment of the present invention, the temperature of the shower head was made further lower and the uniformity of the temperature distribution was more improved. The experimental data support that the shower head according to the first embodiment of the present invention, which includes the heat transfer columns, permits improving planar uniformity in the distribution of the thickness and the quality of the thin film formed on the wafer W by the thermal decomposition reaction of the raw material gas. Incidentally, heat transfer columns having a rectangular cross section were used in this simulation. However, it is desirable for the heat transfer columns to have a circular cross section in view of the conductance of the gas flow.

Also, it has been confirmed that the temperature on the surface (lower surface) of the shower head 40 can be controlled in the present invention at a level lower by about 10°C than that in the prior art even in the case where the mounting table 5 is actually heated to high temperatures of 300 to 700°C as pointed out previously. For example, where the temperature of the shower head 40 was set at 160°C, with the temperature of the mounting table 5 set at 524°C and 653°C, the temperature of conventional shower head was actually elevated to about 174°C and about 182°C, respectively, by the radiation heat generated from the mounting table. In the first embodiment of the present invention, however, it was possible to suppress the temperature elevation to about 164°C and about 172°C, respectively.

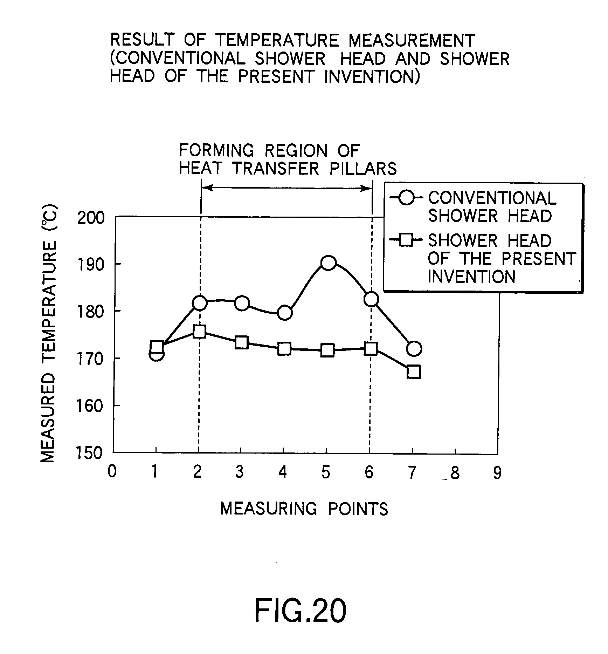

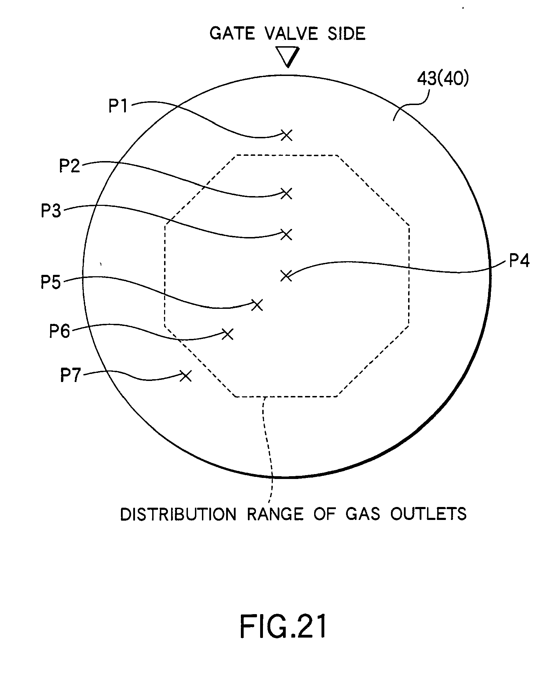

FIG. 20 is a graph showing the temperature of the shower head 40 according to the first embodiment of the present invention and the temperature of the conventional shower head at each of the measuring points shown in FIG. 21, covering the case where the temperature of the mounting table was set at 653°C and the temperature of the shower head was set at 160°C. As shown in the graph of FIG. 21, it has been confirmed that the heat transfer columns 42e produced the effect of making the temperature on the lower surface (shower plate 43) of the shower head lower than that in the conventional shower head. In addition, it has been confirmed that the heat transfer columns 42e produced the effect of making uniform the temperature distribution in the central portion and the peripheral portion of the shower head. To be more specific, when it comes to the measuring points 2 to 6 in the region for forming the heat transfer columns (within the wafer-arranging region), the temperatures for the conventional shower head were high, i.e., 180.1 to 191.1°C, the temperature difference ΔT being 11°C. On the other hand, the temperatures for the shower head according to the first embodiment of the present invention were lower than those for the conventional shower head, i.e., 172.2 to 175.8°C, the temperature difference ΔT being 3.6°C. It has been confirmed that the difference in temperature between the central portion and the peripheral portion on the lower surface of the shower head was not larger than 5°C in the present invention, supporting that the temperature was controlled more uniformly in the present invention, compared with the conventional shower head.

The decomposition temperatures of Pb(thd)₂, Zr(OiPr)(thd)₃ and Ti(OiPr)₂(thd)₂ constituting the raw material gases are about 230°C, 230°C and 235°C, respectively. However, where the temperature inside the shower head 40 is not lower than 220°C, it is worried about that nonuniform thermal decomposition of the raw material gases (film-forming raw materials) may be actually brought about in a high temperature region of the passage within the shower head 40 so as to give adverse effect to the controllability and the uniformity of the composition of the thin film formed on the wafer W. Also, the solid material formed by the thermal decomposition of the raw material gases within the shower head 40 is attached as a foreign substance to the wafer W so as to cause a defect in the film formation. Particularly, since the final thermal decomposition temperature of Pb(thd)₂ is 220 to 240°C, it is necessary for the temperature of the shower head 40 to be lower than 220°C. Also, since it is known to the art that the partial thermal decomposition is started at 150°C, it is necessary for the temperature of the shower head 40 to be not lower than 150°C. It follows that it is desirable for the temperature of the shower head 40 to fall within a range of 160 to 180°C, e.g., to be set at 170°C. As apparent from the graph of FIG. 20 referred to above, in the shower head 40 according to the first embodiment of the present invention, which is provided with the heat transfer columns 42e, the measured temperature was lower than that for the conventional shower head in substantially the entire region, and the temperature was controlled at about the desired temperature of about 170°C. It follows that the heat dissipating effect produced by the heat transfer columns 42e is expected to produce the effect of suppressing the thermal decomposition reaction of the raw material gases within the shower head 40.

In the case of the first embodiment of the present invention, the temperature of the shower head 40 is maintained at a level of about 170°C as pointed out above so as to make it possible to avoid without fail the generation of the undesirable thermal decomposition of the raw material gases in the passage of the raw material gases inside the shower head 40. It follows that it is possible to form a thin film of, for example, PZT having a desired composition and a uniform thickness on the wafer W.

[Second Embodiment]
A second embodiment of the present invention will now be described.
In the first embodiment described above, employed is the shower head 40 provided with the heat transfer columns 42e to make it possible to dissipate the heat to the back surface side of the shower head 40 through the heat transfer columns 42e. In addition, the temperature of the shower head 40 can be controlled by the temperature control mechanism 90. However, where a film is formed on the surface (lower surface) of the shower head 40, the heat reflected by the shower head 40 before formation of the film is absorbed by the film formed on the lower surface of the shower head, with the result that it is not able in some cases to suppress sufficiently the temperature elevation with time of the shower head 40 by relying on the heat transfer columns 42e and the temperature control mechanism 90 alone. It follows that a nonuniformity of the film quality and the film composition is caused among the wafers.

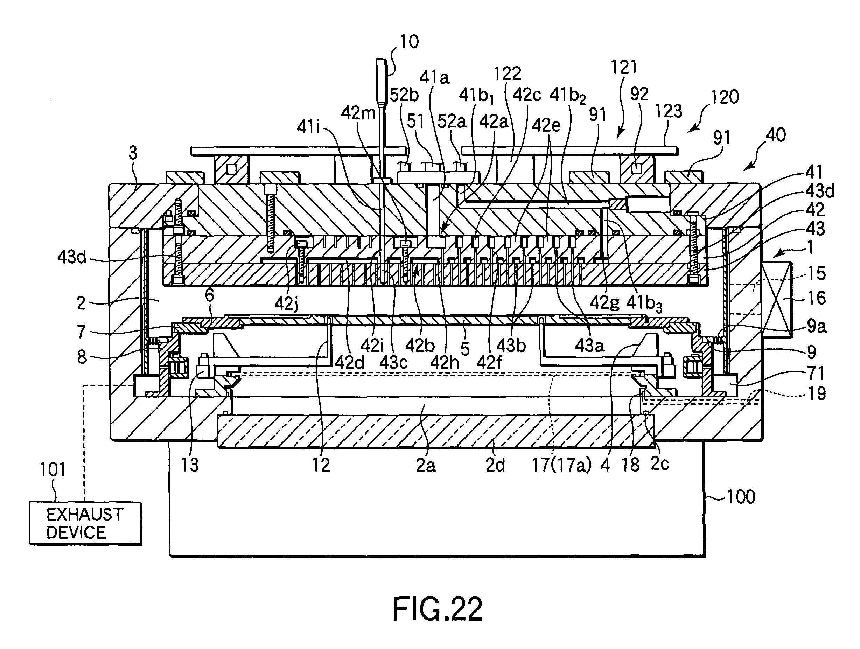

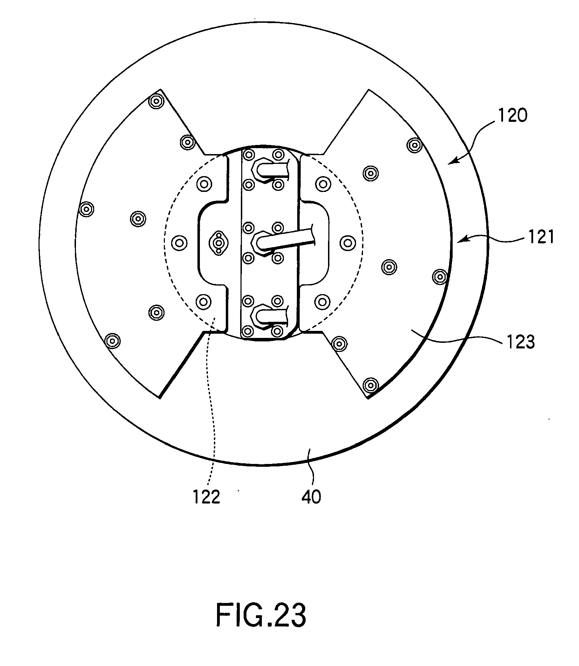

Such being the situation, a construction capable of overcoming the inconvenience noted above is employed in the second embodiment of the present invention. Specifically, FIG. 22 is a cross sectional view showing the construction of a film-forming apparatus according to the second embodiment of the present invention, and FIG. 23 is a plan view of the film-forming apparatus shown in FIG. 22. The film-forming apparatus according to the second embodiment is substantially equal in the basic construction to the apparatus according to the first embodiment and, thus, the reference numerals are commonly put to the constituting members of the apparatuses for the first and second embodiments of the present invention in respect of the corresponding members of the apparatus so as to avoid the overlapping description. Also, the O-ring, the O-ring groove, screws, etc. shown in FIG. 22 are exactly equal to those shown in FIG. 1 and, thus, the reference numerals thereof are also omitted from FIG. 22.

The apparatus according to the second embodiment comprises a temperature control mechanism 120 of the shower head 40 including the heater 91 and the coolant passage 92 equal to those used in the first embodiment and a heat dissipating member 121 formed further inside the inner heater 91. The heat dissipating member 121 is formed of a material having a good heat conductivity such as aluminum, copper, an aluminum alloy or a copper alloy and includes a connecting section 122 formed in the inside region (heat transfer column-forming region) of the upper surface of the shower head 40 and connected to the shower head 40 and a heat sink plate (heat dissipating section) 123 mounted to the upper edge of the connecting section 122 and fan-shaped in a manner to expand outward. Incidentally, the power supply to the heater 91 and the temperature, flow rate, etc. of the coolant circulated within the coolant passage 92 are controlled as in the first embodiment described previously.

In the heat dissipating member 121, the heat generated from the shower head 40 is transmitted to the heat sink plate 123 through the connecting portion 122 to be dissipated from the surface of the heat sink plate 123. In other words, the heat dissipating member 121 performs the function of dissipating the heat generated in the central portion of the shower head 40 to the outer atmosphere. Also, the heat sink plate 123 of the heat dissipating member 121 is in contact with the coolant passage 92 included in the temperature control mechanism 120 so as to enhance further the cooling effect.

Upon providing the heat dissipating member, even if a film is formed on the surface of the shower head 40 during the film-forming operation on the surface of the wafer W, thereby lowering the reflectance of the shower head 40 and, thus, to cause the heat generated from the side of the mounting table 5 to be absorbed by the shower head 40, the heat in the central portion of the shower head 40 is effectively dissipated through the heat transfer columns and the heat dissipating member 121. It follows that it is possible to control uniform the temperature of the shower head 40 so as to suppress the temperature elevation with time. In other words, the temperature control can be performed with a high precision.

Since the heat inside the shower head 40 can be dissipated effectively as described above, it is possible to prevent the temperature elevation with time of the shower head 40 during the film-forming operation on the wafer W. It is also possible to improve the uniformity of the heat of the shower head so as to permit the temperature control of the shower head 40 to be performed with a high stability. Incidentally, the shape of the heat dissipating member is not particularly limited. The shape of the heat dissipating member can be determined appropriately in view of the required heat dissipating capability.

The effect that can be produced in the case of actually performing the temperature control described above will now be described.

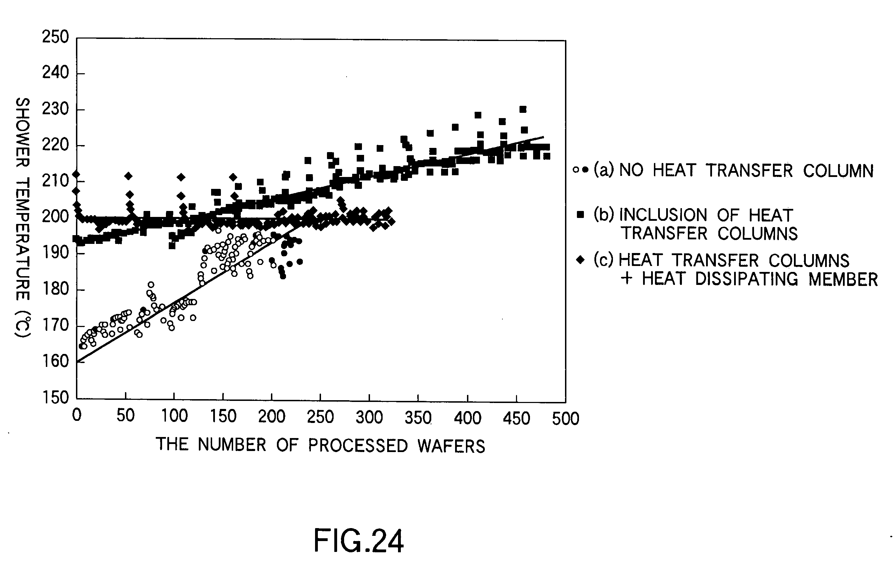

FIG. 24 is a graph showing the relationship between the number of wafers that were consecutively processed for forming a PZT film and the shower head temperature, covering the cases of using (a) the conventional shower head not including the heat transfer columns, (b) the shower head for the first embodiment, in which heat transfer columns were included, and (c) the shower head for the second embodiment including both the heat transfer columns and the heat dissipating member. As apparent from the graph of FIG. 24, the shower head temperature was rapidly elevated with increase in the number of processed wafers in the case of the conventional shower head (a) not including the heat transfer columns. However, the temperature elevation was markedly suppressed in the case of using the shower head (b) including the heat transfer columns. Further, the temperature elevation of the shower head was scarcely observed in the case of using the shower head (c) including the heat dissipating member in addition to the heat transfer columns, supporting that the temperature control of the shower head was performed with a high precision. Since the temperature of the shower head was stable with time in the case of the shower head (c) including both the heat transfer columns and the heat dissipating member, the Pb/(Zr + Ti) ratio and the wafer-to-wafer fluctuation in thickness of the PZT films were found to be ±1.9% and +2.0%, respectively, after formation of 300 PZT films, compared with ±2.7% and ±2.1% for the shower head (b), supporting that the uniformity of the process was satisfactory in the case of using the shower head (c). On the other hand, the Pb/(Zr + Ti) ratio and the wafer-to-wafer fluctuation in thickness of the PZT films were found to be very large after formation of 300 PZT films, i.e., ±7.3% and ±4.6%, respectively, in the case of using the shower head (a) not having the heat transfer columns included therein.

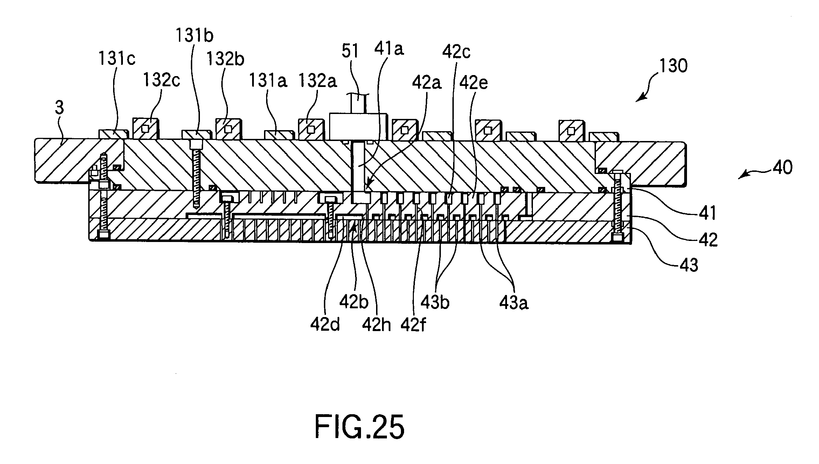

[Third Embodiment]
A third embodiment of the present invention will now be described.
In order to realize the temperature control of the shower head with a high precision as in the example of the construction shown in FIGS. 22 and 23, it is desirable to arrange a heating means and a cooling means in a manner to permit the heating and the cooling to be performed over a large range on the upper surface of the shower head 40. In view of the particular situation, a temperature control mechanism 130 is formed by alternately arranging annular heaters 131a, 131b, 131c and annular coolant passages 132a, 132b and 132c on the upper surface of the shower head 40 as shown in FIG. 25, thereby making it possible to heat and cool substantially the entire region of the upper surface of the shower head 40. The power supply to these heaters 131a, 131b and 131c and the temperature and the flow rate of coolant circulated in the coolant passages 132a, 132b and 132c are controlled based on the detection signal of the thermocouple (not shown) by the feed back control similar to that performed by the controller 110 used in the first embodiment described previously. In this case, it is possible to control collectively supplying the power to the heaters 131a, 131b, 131c and the temperature and/or the flow rate of the coolant circulated into the coolant passages 132a, 132b and 132c. However, it is also possible to perform the zone control in which supplying power, etc. are independently controlled so as to perform the control with a higher precision.

Alternatively, it is also possible to arrange a temperature control mechanism 130' in which cooling gas supply devices 133a, 133b, 133c for supplying a cooling gas onto the upper surface of the shower head 40 are used in place of the coolant passages 132a, 132b, 132c. The temperature control mechanism 130' of the particular construction permits cooling the shower head 40 by supplying a cooling gas to a desired portion on the upper surface of the shower head 40. In this case, the cooling of the shower head 40 can be controlled by controlling the supply rate of the cooling gas. Of course, any of the collective control and the zone control can be employed in this case, too. Various constructions can be employed in each of the cooling gas supply devices 133a, 133b and 133c. For example, the cooling gas supply device can be constructed by arranging a plurality of cooling gas outlets in a manner to form a circular configuration. Also, the cooling gas supply device can be constructed to include an annular cooling gas outlet. Supplying the power to the heaters 131a, 131b, 131c and the gas supply rate to the cooling gas supply devices 133a, 133b, 133c can be controlled based on the detection signal of the thermocouple (not shown) by the feed back control similar to that performed by the controller 110 used in the first embodiment described previously. It is also possible to perform the zone control described previously.

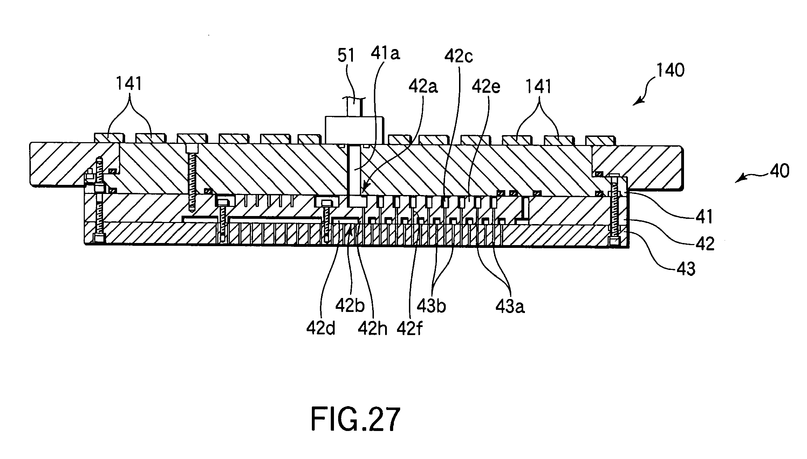

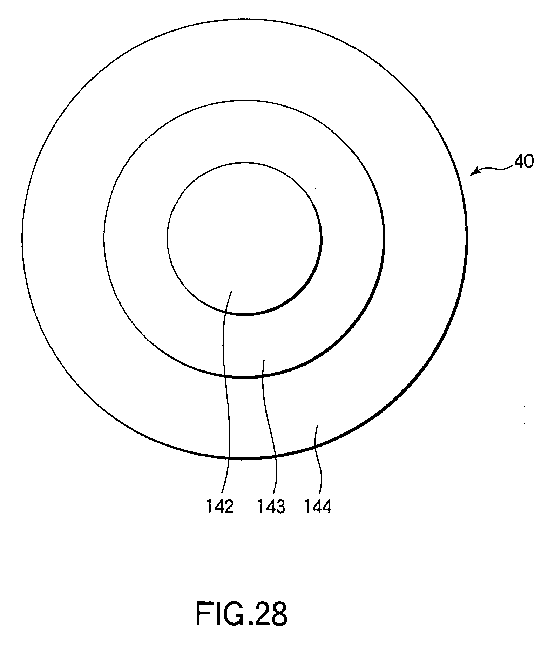

Further, it is possible to realize the temperature control with a high precision by using a temperature control mechanism 140 formed by arranging a plurality of thermoelectric elements 141 such as a Peltier element in a manner to cover substantially the entire region of the upper surface of the shower head 40, as shown in FIG. 27. The thermoelectric element 141 generates heat upon application of voltage thereto to permit the shower head 40 to be heated by the heat generated from the thermoelectric element 141. Also, the heat is absorbed by the thermoelectric element 141 if voltage of a polarity opposite to that of the voltage applied in the stage of generating heat is applied to the thermoelectric element 141 so as to make it possible to cool the shower head 40. In this case, it is desirable to arrange a cooling means such as a coolant passage for releasing the heat absorbed by the thermoelectric element 141. Supplying the power to the plural thermoelectric elements 141 can be performed based on the detection signal of the thermocouple (not shown) by the feed back control similar to that performed by the controller 110 used in the first embodiment described previously. Also, supplying the power to the thermoelectric elements 141 can be performed collectively. It is also possible to divide the thermoelectric elements 141 into a plurality of zones so as to perform the supplying the power control for each of the divided zones. For example, it is possible to divide the upper surface of the shower head 40 into three concentric zones consisting of a central zone 142 corresponding to the central portion, an intermediate zone 143 positioned outside the central zone 142, and an outside zone 144 on the outermost side, as shown in FIG. 28. In this case, it is possible to control the power supply to the thermoelectric elements 141 included in each of these zones independently, thereby achieving the control with a higher precision.

Where it is impossible to arrange the temperature control mechanism in a manner to cover substantially the entire region of the upper surface of the shower head 40 in the third embodiment because of the constructions of the heaters and the cooling devices, it is possible to arrange the heat dissipating member 121 used in the second embodiment on that region of the surface of the shower head 40 which is to be cooled sufficiently.

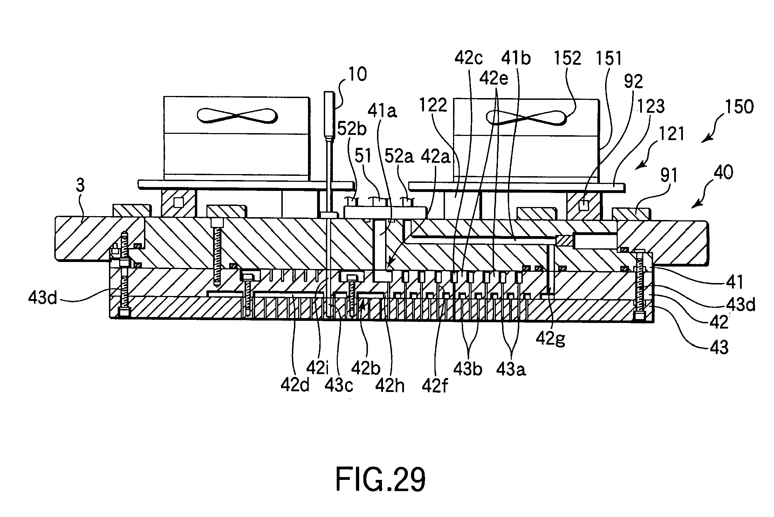

[Fourth Embodiment]
A fourth embodiment of the present invention will now be described. FIG. 29 is a cross sectional view showing the construction of the shower head portion included in the film-forming apparatus according to the fourth embodiment of the present invention. The film-forming apparatus according to the fourth embodiment is substantially equal in the basic construction to the apparatus according to the first embodiment and, thus, the reference numerals are commonly put to the constituting members of the apparatuses for the first and fourth embodiments of the present invention in respect of the corresponding members of the apparatus so as to avoid the overlapping description. Also, the O-ring, the O-ring groove, screws, etc. shown in FIG. 29 are exactly equal to those shown in FIG. 1 and, thus, the reference numerals thereof are also omitted from FIG. 29.

In the fourth embodiment, a temperature control mechanism 150 of the shower head 40 is prepared by adding a heat sink block 151 and a motor fan 152 to the constituting factors of the temperature control mechanism 120 employed in the second embodiment described previously. In FIG. 29, the reference numerals equal to those used in the second embodiment are put to the members of the apparatus shown in FIG. 29, which correspond to the constituting factors of the temperature control mechanism 120 of the second embodiment.

As shown in FIG. 29, the heat sink block 151 is mounted on the heat sink plate 123 included in the heat dissipating member 121, and the motor fan 142 is arranged on the heat sink block 151. The heat of the shower head 40 is transmitted to the heat sink plate 123 via the connecting section 122 and, then, further transmitted from the surface of the heat sink plate 123 to the heat sink block 151 so as to be subjected to the compulsory dissipation by the motor fan 152. The particular system permits achieving a heat dissipation that is more effective than that achieved by the heat dissipation system employed in the second embodiment. Since the heat dissipation from inside the shower head 40 can be performed more effectively, it is possible to further improve the heat dissipation properties of the shower head 40 during the film-forming operation on the wafer W, with the result that it is possible to prevent the temperature elevation with time. It follows that the temperature control of the shower head 40 can be performed with a high stability. Incidentally, it is possible to arrange the motor fan 152 sideward of the heat sink block 151.

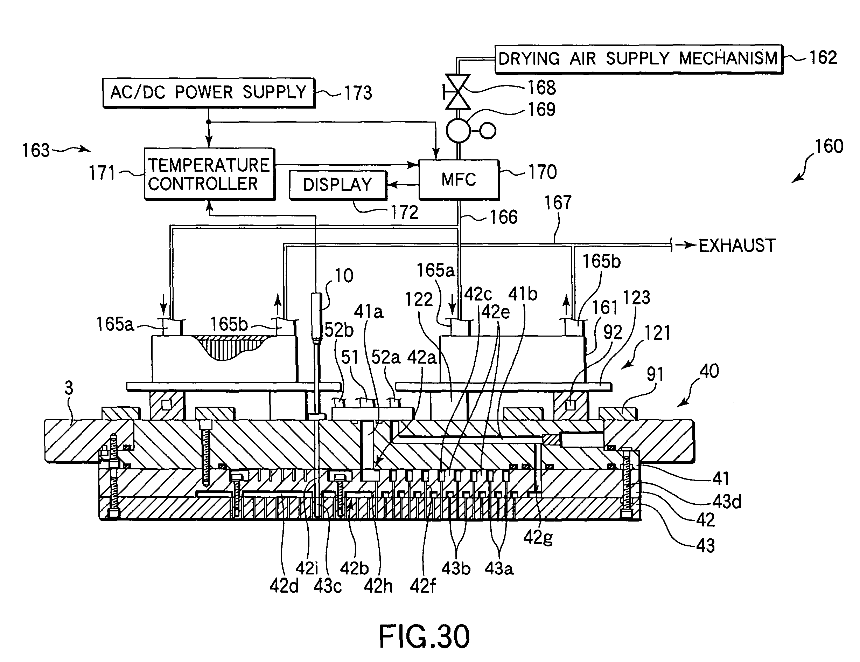

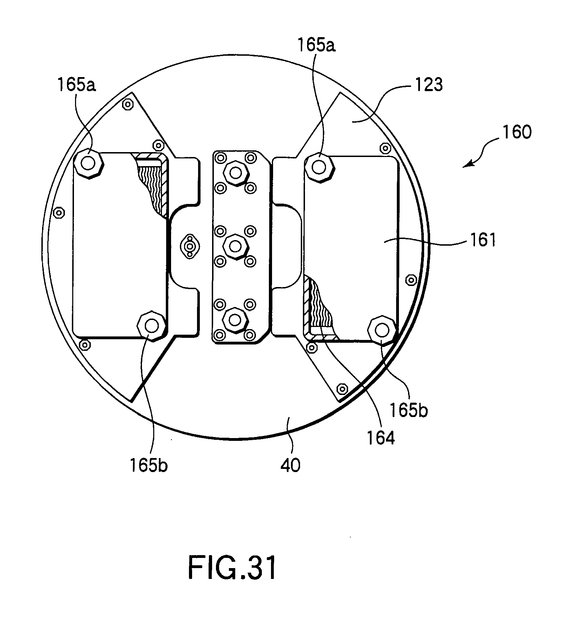

[Fifth Embodiment]
A fifth embodiment of the present invention will now be described. Specifically, FIG. 30 is a cross sectional view showing the construction of the shower head portion of the film-forming apparatus according to the fifth embodiment of the present invention, and FIG. 31 is a plan view of the apparatus shown in FIG. 30. The film-forming apparatus according to the fifth embodiment is substantially equal in the basic construction to the apparatus according to the first embodiment and, thus, the reference numerals are commonly put to the constituting members of the apparatuses for the first and fifth embodiments of the present invention in respect of the corresponding members of the apparatus so as to avoid the overlapping description. Also, the O-ring, the O-ring groove, screws, etc. shown in FIG. 30 are exactly equal to those shown in FIG. 1 and, thus, the reference numerals thereof are also omitted from FIG. 30.

In the fifth embodiment, a temperature control mechanism 160 of the shower head 40 is prepared by adding a heat sink member 161, a dry air supply mechanism 162 for supplying a dry air used as a heat exchange medium to the heat sink member 161 and a temperature control section 163 for controlling the temperature of the dry air based on the temperature of shower head 40 to the constituting factors of the temperature control mechanism 120 employed in the second embodiment. Incidentally, In FIGS. 30 and 31, the reference numerals equal to those used in the second embodiment are put to the members of the apparatus corresponding to the constituting factors of the temperature control mechanism 120 of the second embodiment.

The heat sink member 161 is arranged on the heat sink plate 123 included in the heat dissipating member 121, and a large number of fins 164 is arranged within the heat sink member 161. Inlets 165a for introducing the drying air into the heat sink member 161 and outlets 165b for discharging the drying air from the heat sink member 161 are formed in the heat sink member 161. The inlets 165a are connected to the drying air supply mechanism 162 by a pipe 166, and a pipe 167 is connected to the outlets 165b. As a result, the drying air can be supplied into the heat sink member 161.

Mounted to the pipe 166 are a valve 168 that is operated manually, a regulator 169, and a mass flow controller 170 that also provides a constituting factor of the temperature control section 163.

The temperature control section 163 includes a temperature controller 171. Upon receipt of the detection signal of the thermocouple 10 serving to detect the temperature of the shower head 40, the temperature controller 171 transmits a flow rate control signal to the mass flow controller 170 based on the detection signal of the thermocouple 10. As a result, the flow rate of the drying air supplied from the drying air supply mechanism 162 to the heat sink member 161 is controlled so as to set constant the temperature of the shower head 40. Like the temperature controller 110 used in the first embodiment, the temperature controller 171 also serves to turn the heater 91 on or off and to control the temperature or the flow rate of the coolant flowing within a coolant passage 92. Incidentally, an electric power is supplied from an AC/DC power supply 173 to the temperature controller 171 and the mass flow controller 170. Also, a display 172 is connected to the mass flow controller 170 so as to display, for example, the flow rate information.

According to the construction described above, the heat of the shower head 40 is transmitted to the heat sink plate 123 via the connecting section 122 and, then, further transmitted from the surface of the heat sink plate 123 to the heat sink member 161. As a result, a heat exchange is carried out promptly within the heat sink member 161 by the drying air supplied from the drying air supply mechanism 162 into the heat sink member 161, thereby permitting the heat to be dissipated. It should be noted in particular that, since a large number of fins 164 are arranged within the heat sink member 161, the heat exchange can be performed highly rapidly. It follows that the heat dissipation from the shower head 40 can be performed highly effectively. In addition, it is possible to control the heat dissipation with a high precision by controlling the flow rate of the drying air supplied into the heat sink member 161. It follows that it is possible to improve further the heat dissipation properties of the shower head 40 during the film-forming operation on the wafer W and to prevent more effectively the temperature elevation with time. Such being the situation, the temperature of the shower head 40 can be controlled with a high stability at a level higher than that in the fourth embodiment.

Incidentally, the heat exchange medium used is not limited to the drying air, and it is possible to use another gas as the heat exchange medium. Also, it is unnecessary to arrange the heater 91 and the coolant passage 92, as far as it is possible to control sufficiently the flow rate of the heat exchange medium such as the drying air and to control the temperature of the shower head 40.

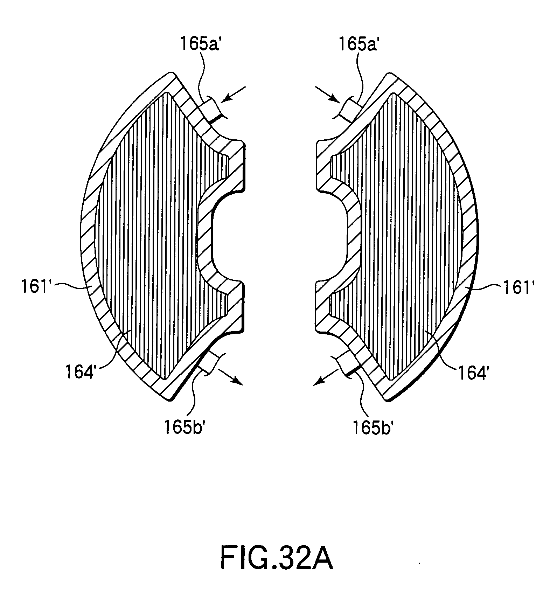

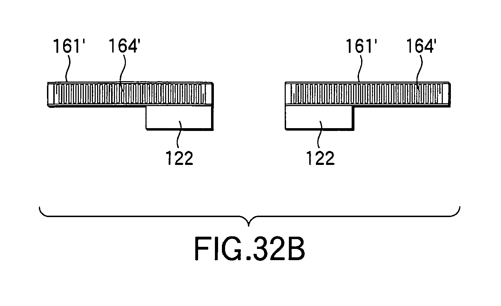

In the embodiment described above, the heat sink member 161 is arranged on the heat sink plate 123. However, it is also possible to arrange a heat sink member 161' that is fan-shaped like the heat sink plate 123 directly on the connecting section 122 without arranging the heat sink plate 123, as shown in FIGS. 32A and 32B. A large number of fins 164' are arranged within the heat sink member 161', and an inlet 165a' for introducing the drying air into the heat sink member 161' and an outlet 165b' for discharging the drying air from within the heat sink member 161' are formed in the heat sink member 161'. The heat exchange can be performed exactly as in the heat sink member 161 within the heat sink member 161' by permitting the drying air to be circulated within the heat sink member 161'. Incidentally, it is not absolutely necessary for the heat sink member 161' to be fan-shaped.

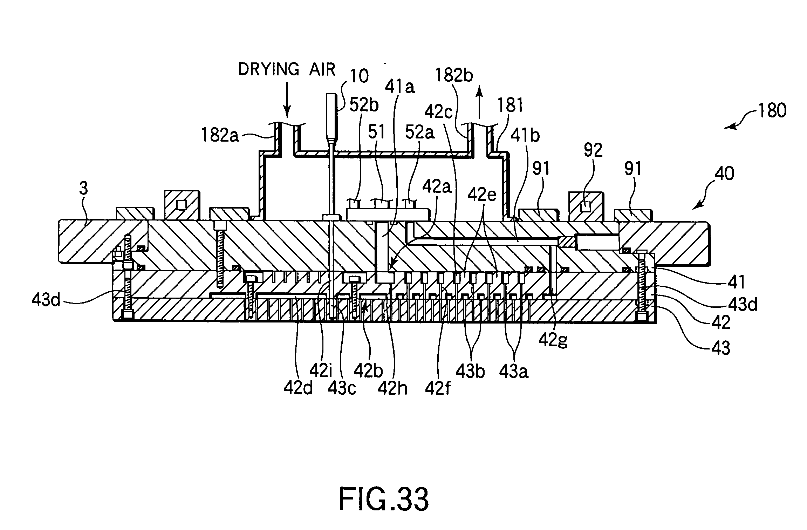

[Sixth Embodiment]
A sixth embodiment of the present invention will now be described. Specifically, FIG. 33 is a cross sectional view showing the construction of the shower head portion of the film-forming apparatus according to the sixth embodiment of the present invention. The film-forming apparatus according to the sixth embodiment is substantially equal in the basic construction to the apparatus according to the first embodiment and, thus, the reference numerals are commonly put to the constituting members of the apparatuses for the first and sixth embodiments of the present invention in respect of the corresponding members of the apparatus so as to avoid the overlapping description. Also, the O-ring, the O-ring groove, screws, etc. shown in FIG. 33 are exactly equal to those shown in FIG. 1 and, thus, the reference numerals thereof are also omitted from FIG. 33.

In the sixth embodiment, a temperature control mechanism 180 of the shower head 40 comprises a cover 181 hermetically closing the central portion of the upper surface of the shower head 40, i.e., the upper portion of the lid 3, in addition to the heater 91 and the coolant passage 92 used in the first embodiment. The cover 181 is provided with an inlet 182a for introducing a drying air used as a heat exchange medium into the region defined by the cover 181 and an outlet 182b for discharging the drying air to the outside. The drying air is introduced into the region inside the cover 181 through the inlet 182a and is discharged from within the space inside the cover 181 through the outlet 182b, thereby forming a stream of the drying air within the space inside the cover 181. In other words, the cover 181 performs the function of the heat exchange member. Incidentally, the power supply into the heater 91 and the temperature, flow rate, etc. of the coolant circulated within the coolant passage 92 are controlled as in the first embodiment described previously.

Since a stream of the drying air is formed inside the hermetically closed cover 181 as described above, a heat exchange is performed between the upper surface of the lid 3 included in the shower head 40 and the drying air to make it possible to dissipate effectively the heat of the shower head 40 and, thus, to control uniformly the temperature of the shower head 40. It follows that it is possible to perform the temperature control with a high precision by suppressing the temperature elevation with time. In this case, it is possible to control the temperature of the shower head 40 with a very high precision by controlling the flow rate of the drying air as in the fifth embodiment described previously. Incidentally, it is not absolutely necessary to arrange the heater 91 and the coolant passage 92 in the case where the temperature control can be performed sufficiently by the heat exchange with the drying air.

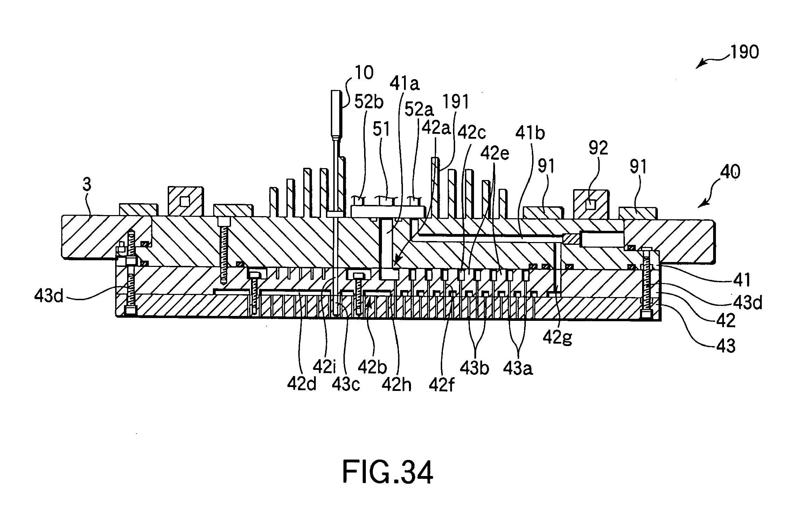

[Seventh Embodiment]
A seventh embodiment of the present invention will now be described. Specifically, FIG. 34 is a cross sectional view showing the construction of the shower head portion included in the film-forming apparatus according to the seventh embodiment of the present invention. The film-forming apparatus according to the seventh embodiment is substantially equal in the basic construction to the apparatus according to the first embodiment and, thus, the reference numerals are commonly put to the constituting members of the apparatuses for the first and seventh embodiments of the present invention in respect of the corresponding members of the apparatus so as to avoid the overlapping description. Also, the O-ring, the O-ring groove, screws, etc. shown in FIG. 34 are exactly equal to those shown in FIG. 1 and, thus, the reference numerals thereof are also omitted from FIG. 34.

In the seventh embodiment, a temperature control mechanism 190 of the shower head 40 comprises a plurality of heat sink fins 191 acting as heat dissipating members in addition to the heater 91 and the coolant passage 92 used in the first embodiment. The heat sink fins 191 are formed integral with the lid 3 in the inner portion of the inner heater 91 in a manner to project upward from the upper surface of the lid 3. Incidentally, the power supply into the heater 91 and the temperature, flow rate, etc. of the coolant circulated within the coolant passage 92 are controlled as in the first embodiment described previously.

The heat sink fin 191 has a large heat dissipating area because of the shape of the fin, with the result that the heat of the shower head 40 can be dissipated effectively from the surface of the heat sink fin 191. In the case of arranging the heat sink fins 191, the heat in the central portion of the shower head 40 is effectively dissipated through the heat transfer columns 42e and the heat sink fins 191 even if the shower head 40 absorbs the heat emitted from the mounting table 5. It follows that the temperature of the shower head 40 can be controlled uniform, and the temperature control can be performed with a high precision by suppressing the temperature elevation with time.

Since the heat inside the shower head 40 can be dissipated effectively as described above, it is possible to prevent the temperature of the shower head 40 from being elevated with time during the film-forming operation on the wafer W. It is also possible to improve the uniformity of the heat of the shower head to make it possible to perform the temperature control of the shower head 40 with a high stability.

The heat sink fins 191 are arranged such that the heat sink fins having the largest height are arranged in the central portion of the shower head and the heat sink fins 191 are arranged in a manner to permit the height of the arranged fins to be gradually lowered toward the peripheral portion of the shower head. What should be noted is that the heat dissipating properties can be most enhanced in the central portion of the lid 3 most requiring the heat dissipation. It is possible to set appropriately the height, the shape, the thickness, the number, etc. of the heat sink fins 191 in accordance with the required heat dissipating properties.

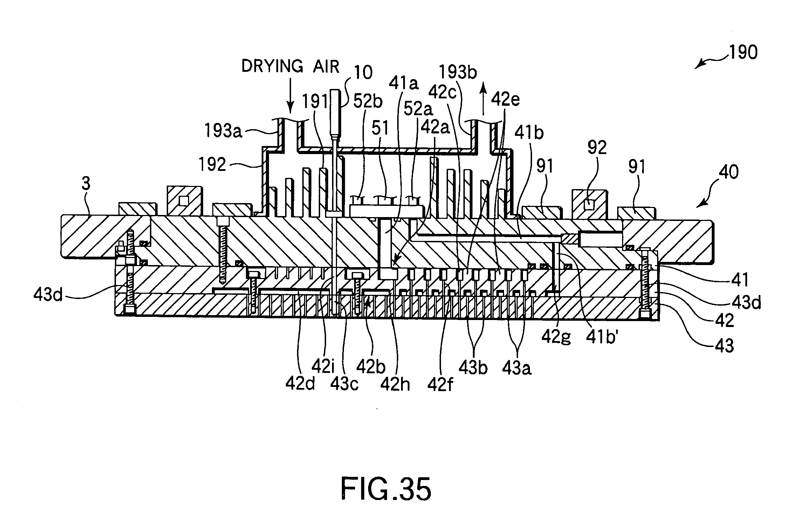

Further, in order to further improve the heat dissipating properties and the temperature controllability, it is desirable to mount a cover 192 in a manner to cover that portion on the surface of the lid 3 of the shower head 40 in which the heat sink fins 191 are mounted, as shown in FIG. 35. In this case, a heat exchange medium such as a drying air is introduced through an inlet 193a formed in the cover 192 into the region inside the cover 192 and is discharged to the outside through an outlet 193b to form a stream of the drying air within the region inside the cover 192, thereby promoting the heat exchange. In this case, the temperature control of the shower head 40 can be performed with a further precision. Also, the temperature of the shower head 40 can be controlled with a very high precision by controlling the flow rate of the drying air as in the fifth embodiment described previously. Incidentally, it is not absolutely necessary to use the heater 91 and the coolant flowing passage 92 in the case of mounting the cover 192 so as to form a stream of the heat exchange medium in the region inside the cover 192.

The present invention is not limited to the embodiments described above and can be modified in various fashions within the technical scope of the present invention. For example, each of the embodiments described above is directed to an apparatus for forming a PZT film on the wafer W. However, the technical idea of the present invention can also be employed in the operation for forming another film such as a W film or a Ti film on the wafer W. Also, the present invention is not limited to a film-forming apparatus. It is also possible to apply the technical idea of the present invention to another gas processing apparatus such as a heat processing apparatus and a plasma processing apparatus. Further, the construction of the shower head is not limited to that employed in each of the embodiments described above. Further, in each of the embodiments described above, the temperature control mechanism of the shower head is mounted on the upper surface of the shower head. However, it is also possible to mount the temperature control mechanism of the shower head inside the shower head. Still further, a semiconductor wafer is used as the target substrate to be processed in each of the embodiments described above. However, it is also possible to employ the apparatus of the present invention for processing another substrate such as a flat display panel (FDP) represented by a glass substrate for the liquid crystal display device (LCD).

### Industrial Applicability

The technical idea of the present invention can be widely applied to a gas processing device in which a raw material gas is supplied into a process chamber through a shower head arranged to face a heated substrate disposed on a mounting table so as to carry out a desired gas treatment.

## Claims

1. A gas processing device, comprising:
a process chamber accommodating a target substrate;
a mounting table arranged within the process chamber for mounting the target substrate;
a process gas discharging mechanism arranged to face the mounting table for discharging the process gas into the process chamber; and
an exhaust mechanism for exhausting the process chamber,
wherein:
the process gas discharging mechanism comprises:
a gas introducing portion for introducing the process gas into the process gas discharging portion,
a gas discharging portion having a plurality of gas discharging holes for discharging the process gas toward the mounting table, and
a gas diffusing portion arranged between the gas introducing portion and the gas discharging portion; and
wherein the gas diffusing portion includes:
a plurality of heat transfer columns for performing the heat transmission between the gas introducing portion and the gas discharging portion, and
a gas diffusing space communicating with the gas discharging holes and constituting the portion other than the heat transfer columns.

2. The gas processing device according to claim 1, wherein each of the plural heat transfer columns has a circular cross portion.

3. The gas processing device according to claim 1 or 2, wherein the ratio S1/S2 of the sum S1 of the cross sectional areas of the heat transfer columns to the cross sectional area S2 of the gas diffusion portion falls within a range of 0.05 to 0.5.

4. The gas processing device according to claim 1, wherein the diameter of the heat transfer column falls within a range of 2 to 12 mm.

5. A gas processing device, comprising:
a process chamber accommodating a target substrate;
a mounting table arranged within the process chamber for mounting the target substrate;
a process gas discharging mechanism arranged to face the target substrate disposed on the mounting table for discharging the process gas into the process chamber; and
an exhaust mechanism for exhausting the process chamber,
wherein:
the process gas discharging mechanism comprises:
a first plate onto which each of a first process gas and a second process gas is introduced,
a second plate connecting to the surface of the first plate,
a third plate connecting to the second plate and including a plurality of first and second gas discharging holes formed corresponding to the target substrate disposed on the mounting table,
a first gas diffusion portion formed between the first plate and the second plate, and
a second gas diffusion portion formed between the second plate and the third plate; and
wherein
the first gas diffusion portion has:
a plurality of first columns connected to the first plate and the second plate, and
a first gas diffusion space communicating with the first gas discharge holes and constituting the portion other than the plural first columns;
the second gas diffusion portion has:
a plurality of second columns connected to the second plate and the third plate, and
a second gas diffusion space communicating with the second gas discharging holes and constituting the portion other than the plural second columns, and
wherein:
the introduced first process gas is discharged from the first gas discharging holes through the first gas diffusion space, and the introduced second process gas is discharged from the second gas discharging holes through the second gas diffusion space.

6. The heat processing device according to claim 5, wherein a gas passage that permits the first gas diffusion space to communicate with the first gas discharging holes is formed in each of the plural second columns in manner to extend in the axial direction.

7. A heat processing device, comprising:
a process chamber accommodating a target substrate;
a mounting table arranged within the process chamber for mounting the target substrate;
a process gas discharging mechanism arranged in a position to face the target substrate disposed on the mounting table for discharging first and second process gases into the process chamber; and
an exhaust mechanism for exhausting the process chamber,
wherein:
the process gas discharging mechanism includes:
a gas introducing portion for introducing the first and second process gases into the process gas process gas discharging mechanism,
a gas discharging portion provided with a plurality of first and second gas discharging holes for discharging the first process gas and the second process gas toward the mounting table, and
first and second flat gas diffusion portions stacked one upon the other in the region between the gas introducing portion and the gas discharging portion;
wherein the first gas diffusion portion includes:
a plurality of first columns for performing the heat transmission between the gas discharging portion and the gas introducing section, and
a first gas diffusion space communicating with the first gas discharging holes and constituting the portion other than the plural first columns;
the second gas diffusion portion includes:
a plurality of second columns each provided with a gas flowing hole through which the first process gas flows, and
a second gas diffusion space communicating with the second gas discharging holes and constituting the portion other than the plural second columns; and
wherein:
the introduced first process gas is discharged from the first gas discharging holes through the first gas diffusion space, and the introduced second process gas is discharged from the second gas discharging holes through the second gas diffusion space.

8. The gas processing device according to any one of claims 5 to 7, wherein each of the first columns has a circular cross section.

9. The gas processing device according to any one of claims 5 to 8, wherein the ratio S1/S2 of the sum S1 of the cross sectional areas of the first columns to the cross sectional area S2 of the second gas diffusion portion falls within a range of 0.05 to 0.50.

10. The gas processing device according to any one of claims 5 to 9, wherein each of the first columns has a diameter of 2 to 12 mm.

11. The gas processing device according to any one of claims 5 to 10, wherein the process chamber is shaped to permit a columnar processing space to be arranged within a polygonal housing, and the exhaust mechanism includes a first exhaust passage formed in the bottom portion of the housing in a manner to communicate with the processing space and to surround the processing space, and a second exhaust passage arranged in the height direction in each of a plurality of diagonally-facing corner portions of the housing and communicating with the first exhaust passage.

12. The gas processing device according to any one of claims 1 to 11, further comprising a temperature control mechanism arranged in an upper portion of the process gas discharging mechanism for controlling the temperature of the process gas discharging mechanism.

13. The gas processing device according to claim 12, wherein the temperature control mechanism includes a heater for heating the process gas discharging mechanism and a coolant passage through which flows a coolant for cooling the process gas discharging mechanism.

14. The gas processing device according to claim 12, wherein the temperature control mechanism includes a heater for heating the process gas discharging mechanism and a cooling gas supply device for supplying a cooling gas to a prescribed position on the upper surface of the process gas discharging mechanism.

15. The gas processing device according to claim 12, wherein the temperature control mechanism includes a plurality of thermoelectric elements arranged on the upper surface of the process gas discharging mechanism.

16. The gas processing device according to any one of claims 12 to 15, wherein the temperature control mechanism performs the temperature control over substantially the entire region of the process gas discharging mechanism.

17. The gas processing device according to any one of claims 12 to 16, further comprising a heat dissipating member for dissipating the heat of the process gas discharging mechanism into the atmosphere.

18. The gas processing device according to claim 17, wherein the heat dissipating member includes a connecting portion connected to the upper surface of the gas discharging mechanism and a heat diffusion portion having a large area and mounted to the connecting portion.

19. The gas processing device according to claim 17 or 18, wherein the temperature control mechanism includes a fan for promoting the heat dissipation from the heat dissipating member.

20. The gas processing device according to claim 17, wherein the heat dissipating member includes a fin formed integral with the process gas discharging mechanism in a manner to project upward from the upper surface of the process gas discharging mechanism.

21. The gas processing device according to claim 12, wherein the temperature control mechanism includes a heat exchange member for exchanging the heat with the gas discharging mechanism and a heat exchange medium supply mechanism for supplying a heat exchange medium into the heat exchange member to form a stream of the heat exchange medium within the heat exchange member.

22. The gas processing device according to claim 21, wherein the heat exchange member includes a large number of fins that are housed therein.

23. The gas processing device according to claim 21, wherein the temperature control mechanism further includes a heat dissipating member for dissipating the heat of the process gas discharging portion into the atmosphere.

24. The gas processing device according to claim 23, wherein the heat dissipating member includes a connecting portion connected to the upper surface of the gas discharging portion and a heat diffusion portion having a large area and mounted to the connecting portion, and the heat exchange member is arranged in contact with the heat diffusion portion.

25. The gas processing device according to claim 24, wherein the heat exchange member includes a large number of fins that are housed therein.

26. The gas processing device according to claim 23, wherein the heat dissipating member includes a fin formed integral with the process gas discharging mechanism in a manner to project upward from the upper surface of the process gas discharging mechanism, and the heat exchange member is arranged in a manner to cover the fin.

27. The gas processing device according to any one of claims 21 to 26, wherein the temperature control mechanism includes a temperature control portion that controls the flow rate of a heat exchange medium introduced into the heat exchange member in accordance with the temperature of the process gas discharging mechanism to control the temperature of the process gas discharging mechanism.

28. A gas processing device, comprising:
a process chamber accommodating a target substrate;
a mounting table arranged in the process chamber for mounting the target substrate;
a process gas discharging mechanism arranged in a position to face the mounting table for discharging the process gas into the process chamber;
an exhaust mechanism for exhausting the process chamber; and
a temperature control mechanism of the process gas discharging mechanism;
wherein the process gas discharging mechanism includes:
a gas introducing portion for introducing the process gas into the process gas discharging mechanism,
a gas discharging portion provided with a plurality of gas discharging holes for discharging the process gas toward the mounting table, and
a gas diffusion portion arranged between the gas introducing portion and the gas discharging portion;
wherein the gas diffusion portion includes:
a heat transfer column for performing the heat transmission between the gas introducing portion and the gas discharging portion, and
a gas diffusion space communicating with the gas discharging hole and constituting the portion other than the heat transfer column; and
wherein the temperature control mechanism includes a heat dissipating mechanism for dissipating the heat transmitted from the lower portion of the process gas introducing portion through the heat transfer column.

29. The gas processing device according to claim 28, wherein the heat dissipating mechanism includes a heat dissipating member for dissipating the heat of the process gas discharging mechanism into the atmosphere.

30. The gas processing device according to claim 29, wherein the heat dissipating mechanism includes a connecting portion connected to the upper surface of the gas discharging mechanism and a heat diffusion portion having a large area and mounted to the connecting portion.

31. The gas processing device according to claim 29 or 30, wherein the heat dissipating mechanism includes a fan for promoting the heat dissipation from the heat dissipating member.

32. The gas processing device according to claim 29, wherein the heat dissipating member includes a fin formed integral with the process gas discharging mechanism in a manner project upward from the upper surface of the process gas discharging mechanism.

33. The gas processing device according to claim 28, wherein the heat dissipating mechanism includes a heat exchange member for exchanging the heat with the gas discharging mechanism and a heat exchange medium supply mechanism for supplying the heat exchange medium into the heat exchange member to form a stream of the heat exchange medium within the heat exchange member.

34. The gas processing device according to claim 33, wherein the heat exchange member includes a large number of fins that are housed therein.

35. The gas processing device according to claim 33, wherein the heat dissipating mechanism further includes a heat dissipating member for dissipating the heat of the process gas discharging mechanism into the atmosphere.

36. The gas processing device according to claim 35, wherein the heat dissipating member includes a connecting portion connected to the upper surface of the gas discharging mechanism and a heat dissipating portion having a large area and mounted to the connecting portion, and the heat exchange member is mounted in contact with the heat diffusion portion.

37. The gas processing device according to claim 36, wherein the heat exchange member includes a large number of fins that are housed therein.

38. The gas processing device according to claim 35, wherein the heat dissipating member includes a fin formed integral with the process gas discharging mechanism in a manner to project upward from the upper surface of the process gas discharging mechanism, and the heat exchange member is arranged to cover the fin.

39. The gas processing device according to any one of claims 33 to 38, wherein the heat dissipating mechanism includes a temperature control portion for controlling the flow rate of the heat exchange medium introduced into the heat exchange member in accordance with the temperature of the process gas discharging mechanism so as to control the temperature of the process gas discharging mechanism.

40. A heat radiating method of a process gas discharging mechanism included in a gas processing device comprising a process chamber accommodating a target substrate, a mounting table arranged within the process chamber for mounting the target substrate, a process gas discharging mechanism arranged in a position to face the mounting table for discharging the process gas into the process chamber, and an exhaust mechanism for exhausting the process chamber, wherein the process gas discharging mechanism includes a gas introducing portion for introducing the process gas into the process gas discharging mechanism, a gas discharging portion provided with a plurality of gas discharging holes for discharging the process gas toward the mounting table, and a gas diffusion portion arranged between the gas introducing portion and the gas discharging portion for diffusing the process gas in the process gas diffusion space provided therein to guide the process gas to the gas discharging hole,
the method comprising:
forming heat transfer columns in the gas diffusion portion; and
carrying out the heat transmission between the gas introducing portion and the gas discharging portion through the heat transfer columns to dissipate the heat from the process gas discharging mechanism.

41. The heat radiating method according to claim 40, wherein the heat transfer column has a circular cross section.

42. The heat radiating method according to claim 40, wherein the ratio S1/S2 of the sum S1 of the cross sectional areas of the heat transfer columns to the cross sectional area S2 of the gas diffusion portion falls within a range of 0.05 to 0.50.

43. The heat radiating method according to any one of claims 40 to 42, wherein a temperature control mechanism is arranged in an upper portion of the process gas discharging mechanism to control the temperature in a lower portion of the process gas discharging mechanism by performing the heat transmission via the heat transfer column.

44. A heat radiating method of a process gas discharging mechanism included in a gas processing device comprising a process chamber accommodating a target substrate, a mounting table arranged within the process chamber for mounting the target substrate, a process gas discharging mechanism arranged in a position to face the target substrate arranged on the mounting table for discharging the process gas into the process chamber, and an exhaust mechanism for exhausting the process chamber,
wherein the process gas discharging mechanism includes a first plate onto which each of a first process gas and a second process gas is introduced, a second plate connecting to the first plate, a third plate connecting to the second plate and provided with a plurality of first and second gas discharging holes formed to conform with the target substrate supported by the mounting table, a first gas diffusion portion arranged between the first plate and the second plate, and a second gas diffusion portion arranged between the second plate and the third plate,
the method comprising:
forming a plurality of first columns in the first gas diffusion portion so as to permit the first plate to be connected to the second plate;
forming a plurality of second columns in the second gas diffusion portion so as to permit the second plate to be connected to the third plate;
carrying out the heat transmission between the first plate and the second plate through the first columns; and
carrying out the heat transmission between the second plate and the third plate through the second columns.

45. The heat radiating method according to claim 44, wherein a gas passage allowing the second gas diffusion space to communicate with the second gas discharging holes is formed in each of the plural first columns in manner to extend in the axial direction.

46. A heat radiation method of the process gas discharging mechanism included in a gas treating device comprising a process chamber accommodating a target substrate, a mounting table arranged in the process chamber for mounting the target substrate, a process gas discharging mechanism arranged in a position to face the target substrate disposed on the mounting table for discharging first and second process gases into the process chamber, and an exhaust mechanism for exhausting the process chamber,
wherein the process gas discharging mechanism includes a gas introducing portion for introducing first and second process gases into the process gas discharging mechanism, a gas discharging portion provided with a plurality of first and second gas discharging holes for discharging each of the first and second process gases toward the mounting table, and first and second flat gas diffusion portions stacked one upon the other in the region between the gas introducing portion and the gas discharging portion,
the method comprising:
forming a plurality of first columns in the first gas diffusion portion and a plurality of second columns each including a gas flowing hole for flowing the first process gas in the second gas diffusion portion; and
carrying out the heat transmission between the gas discharging portion and the gas introducing portion through the first and second columns, thereby dissipating the heat from the process gas discharging mechanism.

47. The heat radiating method according to any one of claims 44 to 46, wherein each of the first columns has a circular cross section.

48. The heat radiating method according to any one of claims 44 to 47, wherein the ratio S1/S2 of the sum S1 of the cross sectional areas of the first columns to the cross sectional area S2 of the second gas diffusion section falls within a range of 0.05 to 0.50.

49. The heat radiating method according to any one of claims 44 to 48, wherein a temperature control mechanism is arranged in an upper portion of the process gas discharging mechanism so as to control the temperature in a lower portion of the process gas discharging mechanism by allowing the heat to be transmitted through the first and second columns.
